(19) Europäisches Patentamt

European Patent Office

Office européen des brevets

(11) EP 0 586 983 B1

(12) EUROPÄISCHE PATENTSCHRIFT

(45) Veröffentlichungstag und Bekanntmachung des Hinweises auf die Patenterteilung:
30.07.1997 Patentblatt 1997/31

(51) Int Cl.⁶: G01R 33/38

(21) Anmeldenummer: 93113712.9

(22) Anmeldetag: 27.08.1993

(54) **Gradientenspulen für Therapietomographen**

Gradient coil system for a therapy tomograph

Système de bobines à gradients pour un tomographe thérapeutique

(84) Benannte Vertragsstaaten:
FR GB NL

(30) Priorität: 09.09.1992 DE 4230145

(43) Veröffentlichungstag der Anmeldung:
16.03.1994 Patentblatt 1994/11

(73) Patentinhaber: BRUKER ANALYTIK GMBH
76287 Rheinstetten (DE)

(72) Erfinder:
• Westphal, Michael, Dr.-Ing.
D-76877 Offenbach (DE)
• Laukien, Günther, Prof. Dr.
D-76287 Rheinstetten (DE)

(74) Vertreter: KOHLER SCHMID + PARTNER
Patentanwälte
Ruppmannstrasse 27
70565 Stuttgart (DE)

(56) Entgegenhaltungen:
EP-A- 0 304 126        EP-A- 0 372 096
WO-A-91/19209        DE-A- 4 029 477
GB-A- 2 229 820

**Beschreibung**

Die Erfindung betrifft eine Kernspinresonanz (NMR)-Meßeinrichtung, insbesondere ein NMR-Tomographiegerät, mit einer vorzugsweise supraleitenden Hauptfeldspule, die in einem Meßvolumen, dessen Zentrum mit einem Koordinatenursprung eines kartesischen x-, y-, z-Koordinatensystems zusammenfällt, ein homogenes statisches Magnetfeld $B_0$ in Richtung der z-Achse des Koordinatensystems erzeugen kann, und mit einem tesseralen Gradientenspulensystem zur Erzeugung magnetischer Gradientenfelder mit im Meßvolumen i.w. linearem Verlauf in einer Richtung senkrecht zur z-Achse, wobei das Gradientenspulensystem aus mindestens vier i.w. gleichen, symmetrisch mit radialem und axialem Abstand zum Koordinatenursprung angeordneten, sattelartigen Teilspulen besteht, die jeweils zwei in azimutaler Richtung um die z-Achse verlaufende, elektrisch leitfähige Segmente aufweisen, von denen ein Segment einen möglichst geringen radialen Abstand $r_1$ und das andere Segment einen möglichst großen radialen Abstand $r_2$ von der z-Achse hat, wobei die beiden azimutalen Segmente einen axialen Abstand voneinander in Richtung der z-Achse aufweisen, durch Leiterabschnitte miteinander verbunden sind und sich gemeinsam auf einer rotationssymmetrischen oder ellipsoiden Fläche r(z) befinden, wobei jede Teilspule mehrere Windungen aufweist.

Eine solche NMR-Meßeinrichtung ist beispielsweise bekannt aus der Druckschrift DE-A-40 29 477.

Während Tomographiesysteme in der Vergangenheit praktisch ausschließlich zur Diagnose benutzt wurden, besteht in Zukunft ein immer größer werdender Bedarf an kombinierten Systemen, bei denen Therapiemaßnahmen mit Tomographiegeräten unmittelbar verfolgt und kontrolliert werden können. Zahlreiche Therapiemaßnahmen, wie z.B. chirurgische, insbesondere mikrochirurgische Eingriffe oder Bestrahlungen erfordern dabei einen möglichst freien Zugang zum Patienten. Dieser wird jedoch bei herkömmlichen NMR-Systemen durch sämtliche drei felderzeugenden Komponenten, nämlich den Hauptfeldmagneten, das Gradientenspulensystem sowie den HF-Resonator verhindert.

Hinsichtlich des Hauptfeldmagneten ist das Problem bereits durch das aus der DE-A-39 07 927 bekannte Magnetsystem mit einer einer Helmholtzspule ähnlichen Transversalfeldspule gelöst, die aufgrund ihrer Bauart den freien seitlichen Zugang zum Meßvolumen besonders wenig einschränkt.

Das Problem eines möglichst unbehinderten seitlichen Zugriffs durch den HF-Resonator wird in einer parallelen Patentanmeldung des gleichen Anmelders vom selben Anmeldetag mit dem Titel "YIN-YANG-HF-Spule" mit Hilfe der dort beschriebenen asymmetrischen Sattelspule gelöst, wobei die für einen Tomographen wichtige Eigenschaft einer ausreichend hohen Homogenität des erzeugten HF-Feldes erfüllt ist.

Um nun die Durchführung minimalinvasiver Verfahren (sogenannter "Schlüssellochchirurgie") zu ermöglichen, bei denen aus Gründen des mangelnden direkten Sichtfeldes auf die Operationszone wegen der unter Umständen winzigen Operationsöffnung am Patienten ein NMR-Monitoring dem Operateur eine entscheidende Hilfe zur on-line-Beobachtung der Operation an die Hand gibt, sollte der transversale Zugang zum Meßvolumen im Inneren der NMR-Apparatur mit einem möglichst großen seitlichen Zugriffswinkel nicht letztlich durch das Gradientenspulensystem behindert werden.

Es ist beispielsweise aus der Druckschrift EP-A-0 073 402 ein Gradientenspulensystem in Form von Einfach- oder Mehrfach-Sattelspulen bekannt, die sich auf einem azimutalen Abschnitt um die z-Achse jeweils paarweise gegenüberliegen. Ein solches Gradientenspulensystem befindet sich in der axialen Bohrung des Hauptfeldmagneten und durchdringt herkömmlicherweise den axialen Bereich um den Koordinatenursprung, also gerade auch eine durch die oben erwähnte spezielle Konstruktion des Hauptfeldmagneten und des HF-Resonators freigehaltene seitliche Lücke ("GAP"). Da die bekannten Transversalgradientenspulen, insbesondere die üblicherweise zusammen mit diesen verwendeten Abschirmspulen ausgerechnet im Bereich der Mittelebene z = 0 ihre größte Windungsdichte besitzen, geht dabei der Vorteil der Transparenz und Manipulationsmöglichkeit am Patienten aufgrund der speziellen Gestaltung des Hauptfeldmagneten und des HF-Spulensystems wieder völlig verloren. Andererseits würde eine räumliche Anordnung der bekannten Sattelspulen, die auf Zylinderflächen um die z-Achse angeordnet sind, unter der Randbedingung, daß kein Spulenteil in den Lückenbereich hineinragt, zu starken Nichtlinearitäten der erzeuten Gradientenfelder, zu sehr schwachen Gradientenstärken und zu großen Steufeldern im Bereich des Kryostaten, also zum Anwerfen von Wirbelströmen beim Schalten der Gradienten führen, die wiederum die Homogenität des statischen Magnetfeldes $B_0$ im Untersuchungsvolumen beeinträchtigen können.

Aus der eingangs zitierten Druckschrift DE-A-40 29 477 sind tesserale Gradientenspulen für NMR-Tomographiegeräte bekannt, bei denen sich symmetrisch zur Ebene z = 0 und zu einer dazu senkrechten Ebene, beispielsweise y = 0, Teilspulen des Gradientenspulensystems gegenüberliegen, die jeweils zwei azimutale Segmente mit unterschiedlichen radialen Abständen $r_1$ und $r_2$ von der z-Achse aufweisen, welche jeweils die gleiche z-Position besitzen. Durch diese Anordnung soll das vom Gradientenspulensystem erzeugte parasitäre Magnetfeld mit Feldkomponenten senkrecht zur z-Achse, das im Untersuchungsobjekt und im Kryostaten des Grundfeldmagneten Ströme induziert, deutlich verringert werden. Mit einem Satz von zwei Spulenarten dieser Art zu beiden Seiten (bezüglich der xy-Ebene) der oben erwähnten Zugriffslücke zum Untersuchungsvolumen der NMR-Meßeinrichtung ließe sich theoretisch ein Gradientenspulensystem mit den gewünschten Eigenschaften einer ausreichenden Linearität der erzeugten Gradientenfelder, einem relativ geringen Streufeld und einem unbehinderten transversalen Zugriff zum Meßvolumen aufbauen. Um die üblichen Gradientenstärken (typischerweise mindestens 10 m Tesla/m bei einem Strom von ca. 250 A) zu erzeugen, müßte ein solches Spulensystem mindestens etwa 30 Windungen bei einem Leiterquerschnitt von etwa 60 mm$^2$ aufweisen. Diese Windungen wären bevorzugt axial bezüglich der z-Achse hintereinander anzuordnen, wodurch sich eine beträchtliche axiale Ausdehnung einer solchen Spule von etwa 180 mm ergäbe. Um die gewünschte Linearität der erzeugten Gradientenfelder zu erreichen, ist eine azimutale Ausdehnung der Segmente um die z-Achse von mindestens ca. 120° erforderlich, so daß sich z- und y-Gradientenspulen gegenseitig durchdringen würden, die Anordnung eines Systems mit Gradientenspulen für beide Raumrichtungen also nicht realisierbar wäre. Ein radiales Ineinanderstellen der Windungen anstelle von einer axialen Verteilung hingegen würde wiederum zu einer dramatischen Verschlechterung der Linearität der erzeugten Gradientenfelder sowie einer starken Verringerung der Gradientenstärke pro Einheitsstrom führen.

Aufgabe der vorliegenden Erfindung ist es daher, eine NMR-Meßeinrichtung mit einem Gradientenspulensystem der eingangs geschilderten Art dahingehend zu verbessern, daß gleichzeitig x- und y-Gradienten erzeugt werden können, und daß die tesseralen Gradientenspulen einerseits im Meßvolumen ein möglichst lineares magnetisches Gradientenfeld erzeugen, andererseits aber einem seitlichen oder schrägen Zugriff auf das Meßvolumen möglichst überhaupt nicht oder nur sehr wenig im Wege stehen und damit einen maximal freien Zugang zum Meßvolumen eröffnen.

Erfindungsgemäß wird diese Aufgabe dadurch gelöst, daß das radial äußere Segment mit dem radialen Abstand $r_2$ von der z-Achse axial bezüglich der z-Achse näher am Koordinatenursprung angeordnet ist als das radial innere Segment mit dem radialen Abstand $r_1$ von der z-Achse, und daß der im wesentlichen von der Hauptfeldspule gebildete Hauptfeldmagnet eine Raumtemperaturbohrung mit Durchmesser $d_B$ sowie eine Lücke g in axialer Richtung um den Koordinatenursprung aufweist, wobei gilt:

$$1,6 \, g \leq d_B \leq 2,1 g.$$

Mit einer derartigen Anordnung kann, wie im weiteren gezeigt wird, ein tesserales Gradientenfeld erzeugt werden, dessen Linearität im Meßvolumen vergleichbar mit der von von klassischen Sattelspulen oder stromlinienförmigen Spulen erzeugten tesseralen Gradientenfeldern ist, wobei der seitliche Zugriff auf das Meßvolumen durch das erfindungsgemäße Gradientenspulensystem nicht behindert wird und sich zusätzlich der Vorteil eines äußerst geringen parasitären Anteils an radialen Feldkomponenten des erzeugten Gradientenfeldes außerhalb des Meßvolumens ergibt. Wegen der Anordnung aller Leiterelemente beispielsweise einer x-Gradientenspule in einer rotationssymmetrischen Fläche $r_x$ (z) können alle Teilspulen dieser Gradientenspule beispielsweise auf der Oberfläche einer dicht benachbarten Montagefläche $r_{x1}$ (z) montiert werden. Die Oberfläche aller Teile der fertig montierten x-Gradientenspule stellt dann erneut eine ähnliche und dicht benachbarte Fläche dar, auf die die Teilspulen der y-Gradientenspulen - jeweils um 90° gegenüber den entsprechenden Teilspulen der x-Gradientenspule versetzt - aufgelegt und befestigt werden können. Aufgrund von Feldberechnungen läßt sich zeigen, daß die erfindungsgemäßen Spulensysteme zu einem recht befriedigenden Abbildungsverhalten führen.

Auch die erfindungsgemäßen Spulen sollten aus Linearitätsgründen eine azimutale Ausdehnung von ca. 120° besitzen. Dennoch stören sich x- und y-Gradientenspule nicht gegenseitig, wenn sich alle Elemente beispielsweise der x-Spule in einer rotationssymmetrischen Fläche $r_x$ (z) befinden, was mit der erfindungsgemäßen Anordnung ohne weiteres möglich ist. Die x-Spule kann also montiert werden, und die Oberfläche dieser Spule bildet dann ebenfalls eine fast identische rotationssymmetrische Fläche r (z), auf die die Elemente der y-Spule - um 90° gegenüber den Elementen der x-Spule versetzt -montiert werden können.

Durch des Merkmal des Hauptfeldmagneten wird der Platz in der axialen Bohrung des Hauptfeldmagneten durch das Gradientenspulensystem optimal ausgenutzt.

In der eingangs zitierten Druckschrift DE-A-40 29 477 ist zwar in Fig. 9 auch ein Spulensystem gezeigt, bei dem die radial beabstandeten azimutalen Segmente einer Wicklung einen axialen Abstand in Richtung der z-Achse voneinander aufweisen, jedoch sind bei diesem Gradientenspulensystem im Symmetriezentrum, also in der Ebene z = 0 Spulenwicklungen vorgesehen, die einen seitlichen Zugriff in der xy-Ebene auf das Meßvolumen stark behindern oder unmöglich machen würden. Selbst wenn man in dem bekannten Gradientenspulensystem die mittleren Wicklungen in der xy-Ebene weglassen würde, so daß eine seitliche Zugriffslücke frei werden würde, so würden die restlichen Teilspulen immer noch bezüglich der z-Achse in der "entgegengesetzten Richtung" wie das erfindungsgemäße Gradientenspulensystem gekippt sein, nämlich das radial äußere Segment mit dem größeren radialen Abstand von der z-Achse wäre axial vom Koordinatenursprung weiter entfernt als das radial innere Segment mit dem geringeren radialen Abstand von der z-Achse. Damit würde sich im Untersuchungsvolumen wiederum ein ziemlich nichtlinearer Gradientenverlauf ergeben. Die bekannte Anordnung führt daher gerade von dem erfindungsgemäßen System weg.

Bei einer weiteren Ausführungsform ist der axiale Abstand $g_g$ zweier bezüglich der xy-Ebene spiegelbildlich gegenüberliegender Teilspulen in z-Richtung ungefähr gleich der Lücke g. Dadurch wird einerseits die Breite der Lücke nicht weiter eingeschränkt und andererseits bleiben die Gradientenstärke pro Stromeinheit sowie die Linearität des Gradientenfeldes maximal.

Bei einer weiteren bevorzugten Ausführungsform ist der doppelte radiale Abstand $2 \cdot r_2$ der der Lücke nächstgelegenen azimutalen Segmente nur wenig kleiner als der Durchmesser $d_B$ der Raumtemperaturbohrung des Kryostaten bzw. des Hauptfeldmagneten. Dadurch wird der Platz in der axialen Bohrung des Hauptfeldmagneten optimal ausgenutzt und insbesondere die Gradientenstärke pro Stromeinheit sowie die Linearität des Gradientenfeldes maximal.

Bei einer weiteren bevorzugten Ausführungsform ist der Wert des radialen Abstandes $2 \cdot r_1$ der der Achse nächstgelegenen azimutalen Segmente nur wenig größer als der Durchmesser eines hypothetischen Zylinders, der dem Patienten während der Untersuchung ausreichend Platz bietet.

Bei einer weiteren Ausführungsform liegen die radial äußeren Segmente auf einer Zylinderoberfläche mit dem Radius $r_2$ und die radial inneren Segmente auf einer koaxialen Zylinderoberfläche mit dem Radius $r_1$. Dadurch wird einerseits die Herstellung der erfindungsgemäßen Teilspule erleichtert, andererseits sind die Außenkonturen derselben an die üblicherweise zylindrische Axialbohrung des Hauptfeldmagneten einerseits und die Innenkonturen an die normalerweise zylindrische Patientenbohrung andererseits optimal angepaßt.

Bei einer alternativen Ausführungsform können die Segmente allerdings auch auf einer sich zum Koordinatenursprung hin öffnenden Kegeloberfläche liegen. Besonders günstig für die Herstellung der Teilspulen ist eine Ausführungsform, bei der die äußeren und die inneren Segmente jeweils auf der gleichen Kegeloberfläche liegen.

Bei einer weiteren Ausführungsform ist für jede Teilspule eine Kompensationsspule vorgesehen, die im axialen Bereich des radial inneren Segments der Teilspule ein azimutales inneres Segment mit einem radialen Abstand $r'_1$ von der z-Achse aufweist, der von dem radialen Abstand $r_1$ des radial inneren Segments der Teilspule geringfügig, vorzugsweise etwa um die radiale Dikke des Segments verschieden ist. Eine solche Kompensationsspule kann zumindest teilweise die bei Stromdurchfluß durch die Teilspulen entstehenden Drehmomente kompensieren.

Bei einer besonders vorteilhaften Weiterbildung weist die Kompensationsspule ein zweites azimutales Segment auf, das axial in z-Richtung vom Koordinatenursprung weiter beabstandet ist als das erste azimutale Segment der Kompensationsspule, und das einen radialen Abstand $r'_2 > r'_1$ von der z-Achse hat. Eine solche Kompensationsspule stellt eine zweite "gekröpfte" Sattelspule dar, die bei Stromdurchfluß zusammen mit der Teilspule ein Gesamtfeld erzeugt, dessen radialer Feldbeitrag im Bereich der Hauptfeldmagnetspule und des diese üblicherweise umgebenden Kryostaten verschwindend gering ist. Dadurch werden in den Matallstrukturen nur in geringem Maße Wirbelströme, die die Homogenität des von der Hauptspule erzeugten Magnetfeldes im Meßvolumen beeinträchtigen könnten, angeworfen.

Bezüglich ihrer Geometrie können sich Teilspule und Kompensationsspule sehr ähnlich sein, insbesondere sollte $r'_2 \approx r_2$ sein, vorzugsweise $r'_2 = r_2$.

Auch die maximale axiale Erstreckung in Richtung der z-Achse kann bei der Teilspule und der zugehörigen Kompensationsspule etwa die gleiche sein.

Bei Ausführungsformen der Erfindung können sich allerdings die Teilspule und die zugehörige Kompensationsspule in ihrer Windungszahl unterscheiden.

Besonders bevorzugt ist eine Ausführungsform, bei der um jeweils zwei axial bezüglich der z-Achse gegenüberliegende Teilspulen herum auf der Oberfläche eines Zylinders um die z-Achse mit einem Radius $R_2 \geq r_2$ und einer axialen Ausdehnung in z-Richtung, die ungefähr der axialen Ausdehnung des Hauptfeldmagneten ausschließlich der Lücke entspricht, angeordnete Abschirmspulen vorgesehen sind. Durch eine solche Abschirmspule können die bei der erfindungsgemäßen Spulenform ohnehin geringen radialen Feldkomponenten des Gradientenfeldes im Bereich des Hauptfeldmagneten, die prinzipiell störende Wirbelströme verursachen können, weiter unterdrückt werden.

Die Windungen einer solchen Abschirmspule sind bevorzugt mit den Windungen der entsprechenden Gradientenspule in Reihe geschaltet.

Da bereits die erfindungsgemäße Gradientenspule allein nur kleine radiale Feldbeiträge im Bereich des Hauptfeldmagneten erzeugt, ist die Zahl der Windungen einer solchen Abschirmspule kleiner als die Zahl der Windungen der entsprechenden Gradientenspule. Methoden zur Berechnung des optimalen geometrischen Verlaufes der Windungen von solchen Abschirmspulen lassen sich aus Methoden ableiten, die im Falle von herkömmlichen, auf einer einzigen Zylinderoberfläche angeordneten Gradientenspulen, z.B. in der Druckschrift EP-A-0 216 590 angegeben sind.

Die erfindungsgemäßen Spulen können bei Ausführungsformen aus Windungen von Drähten, vorzugsweise Kupferdrähten bestehen. Bei anderen Ausführungsformen können die Spulen zumindest teilweise aus in sich geschlossenem Band, vorzugsweise aus Kupferblech bestehende, sogenannte "stream-line-Spulen" sein. Derartige Stream-line-Spulen sind an sich bekannt aus der Druckschrift EP-A-0 320 285 und weisen die dort geschilderten Vorteile auf.

Besonders bevorzugt ist eine Ausführungsform der erfindungsgemäßen NMR-Meßeinrichtung, bei der zwei um 90° um die z-Achse gegeneinander versetzte Sätze von aus jeweils vier Teilspulen bestehende x- bzw. y-Gradientenspulen vorgesehen sind. Damit wird der Vorteil der erfindungsgemäßen Ausbildung von Teilspulen mit einem relativ geringen Azimutalumfang um die z-Achse von weniger als 90° entsprechend ausgenutzt.

Um Gradientenfelder in jeder Raumrichtung erzeugen zu können, ist bei einer bevorzugten Ausführungsform ein abgeschirmtes z-Gradientenspulensystem zur Erzeugung magnetischer Gradientenfelder mit im Meßvolumen im wesentlichen linearem Verlauf in einer Richtung parallel zur z-Achse vorgesehen, welches aus zwei bezüglich der xy-Ebene spiegelbildlich angeordneten, zylindrischen Wicklungspaaren um die z-Achse mit jeweils einer radial inneren z-Gradientenfeldwicklung und einer radial äußeren Abschirmspulenwicklung besteht.

Um den von den erfindungsgemäßen Gradientenspulen frei gelassenen Platz zwischen den radial äußeren Segmenten und der Patientenbohrung optimal auszunutzen, sind bei einer besonders bevorzugten Weiterbildung der obigen Ausführungsform die toroidalen Wicklungspaare im axialen Bereich der azimutalen Segmente angeordnet, wobei der radiale Abstand $r_4$ der Abschirmspulenwicklung kleiner als der radiale Abstand $r_2$ des radial äußeren Segmentes ist.

Die z-Gradientenfeldwicklung weist bei einer bevorzugten Ausführungsform ungefähr das $(r_4/r_3)^2$-fache an Wicklungen wie die sie umgebende gegenläufige Abschirmspulenwicklung auf, wobei $r_3$ der radiale Abstand der z-Gradientenfeldwicklung von der z-Achse ist. Dadurch kann das Streufeld im Bereich des Kryostaten erheblich reduziert werden. Allgemein kann die Windungszahl der Abschirmspulenwicklung so optimiert werden, daß das Streufeld im Bereich des Kryostaten minimal wird. Im Unterschied zu einer "idealen" Abschirmung sind die Windungen der Abschirmspulenwicklung nicht verteilt, sondern konzentriert angeordnet. Dadurch sind die Wirbelstromstörungen immer noch erheblich kleiner als bei einer nicht aktiv abgeschirmten Spule.

Sowohl die erfindungsgemäßen Gradientenspulen, als auch die Kompensations-, Abschirm- und Zylinderspulen sind üblicherweise in einem Tragekörper mit Kunststoff in der Weise vergossen, daß eine axiale Bohrung um die z-Achse offen bleibt, die zur Aufnahme eines Menschen in das Tomographiesystem geeignet ist.

Bei der erfindungsgemäßen NMR-Meßeinrichtung kann ein axial in die axiale Bohrung des Tragekörpers oder transversal in die Lücke g des Hauptfeldmagneten einschiebbares Hochfrequenz(HF)-Spulensystem zur Erzeugung eines im Meßvolumen im wesentlichen homogenen HF-Feldes in Richtung der x- oder der y-Achse vorgesehen sein.

Besonders bevorzugt ist eine Ausführungsform, bei der das HF-Spulensystem aus einer sattelförmig um die z-Achse angeordneten, symmetrisch zur zy-Ebene und zur xy-Ebene, jedoch asymmetrisch zur zx-Ebene verlaufenden, in sich geschlossenen HF-Spule besteht.

Eine solche sogenannte "YIN-YANG-Spule" ermöglicht einerseits die Erzeugung ausreichend homogener HF-Felder senkrecht zur z-Achse und behindert andererseits nicht den seitlichen Zugriff auf das Meßvolumen.

Bei einer bevorzugten Ausführungsform weist die HF-Spule vier Extremalpunkte $P_1$ bis $P_4$ in Richtung der y-Achse mit den ungefähren, vorzugsweise exakten Koordinaten

$$P_1: \qquad x_1 = 0 \qquad y_1 = +a \qquad z_1 = +a$$

$$P_2: \qquad x_2 = 0 \qquad y_2 = +a \qquad z_2 = -a$$

$$P_3: \qquad x_3 = -a \qquad y_3 = -a \qquad z_3 = 0$$

$$P_4: \qquad x_4 = +a \qquad y_4 = -a \qquad z_4 = 0$$

auf, wobei a jeweils die gleiche bestimmte Streckenlänge bezeichnet.

Die Streckenlänge a kann zwischen 20 und 50 cm vorzugsweise etwa 30 cm betragen.

Die HF-Spule in der erfindungsgemäßen NMR-Meßeinrichtung kann aus Drähten, vorzugsweise Kupferdrähten, von einer oder mehreren Wicklungen bestehen. Sie kann aber auch bei einer anderen Ausführungsform eine aus einem in sich geschlossenen, leitfähigen Band, vorzugsweise aus Kupferblech bestehende Stream-line-spule sein.

Besonders einfach herstellbar ist die YIN-YANG-Spule, wenn sie im wesentlichen der Kontur eines Zylinders mit Radius a um die z-Achse folgt. Auf einem derartigen zylindrischen Wickelkörper kann die Spule dann ohne Probleme gefertigt werden. Außerdem ist auch der Einbau einer HF-Spule mit zylindrischer Außenkontur in die üblicherweise zylindrische Zimmertemperaturbohrung eines NMR-Kryostaten günstiger zu bewerkstelligen als bei einer anderen Formgebung der Außenkontur.

Um den Vorteil einer großen Transparenz bezüglich eines seitlichen Eingriffs oder eines Zugriffs von schräg oben in Richtung auf das Meßvolumen, wie es durch die erfindungsgemäße Gestaltung des Gradientenspulensystems erreicht wird, voll ausnutzen zu können, empfiehlt es sich, als Hauptfeldspule ein System gemäß der oben erwähnten Druckschrift DE-A-39 07 927 mit einem Helmholtz-ähnlichen Aufbau der Transversalfeldspule zu verwenden. Die Merkmale und Vorteile einer derartigen Hauptfeldspule sind in der genannten Druckschrift, auf die hier ausdrücklich vollinhaltlich Bezug genommen wird, ausführlich diskutiert, so daß an dieser Stelle auf eine Wiederholung dieser Merkmale verzichtet werden kann.

Die Erfindung wird im folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln, für sich oder zu mehreren in beliebiger Kombination Anwendung finden. Es zeigen:

Fig. 1    ein Hauptfeldmagnetsystem mit transversaler Zugriffsmöglichkeit nach dem Stand der Technik in vereinfachter, schematischer Schnittdarstellung in einer die zentrale Längsachse des Magnetsystems enthaltenden Radialebene;

Fig. 2    eine perspektivische Gesamtansicht der erfindungsgemäßen NMR-Meßeinrichtung mit zugehörigem Kryostaten für eine supraleitende Hauptfeldmagnetspule;

Fig. 3    ein Schnitt durch die seitliche Zugriffslücke des in Fig. 2 dargestellten Systems mit Blick auf die Patientenbohrung einer der beiden Hauptspulenhälften;

Fig. 4    eine in einem kartesischen Koordinatensystem mit Koordinatenursprung im Zentrum des Meßvolumens aufgespannte YIN-YANG-Spule;

Fig. 5a    eine YIN-YANG-Spule, die im wesentlichen der Kontur eines Zylinders folgt;

Fig. 5b    eine YIN-YANG-Spule mit angedeuteten HF-Feldlinien;

Fig. 6    einen Längsschnitt durch eine Helmholtz-artige HF-Sendespule nach dem Stand der Technik;

Fig. 7    einen Horizontalschnitt durch eine "nahezu" abgeschirmte z-Gradientenspule;

Fig. 8    einen die xz-Ebene enthaltenden Horizontalschnitt durch das erfindungsgemäße Gradientenspulensystem;

Fig. 9    eine perspektivische Ansicht von erfindungsgemäß "gekröpften" Sattelspulen als Teilspulen eines Gradientenspulensystems mit

        a) Drahtwicklungen und
        b) bandförmigem Aufbau;

Fig. 10    die Feldverteilung einer klassischen asymmetrischen Sattelspule in der xz-Ebene;

Fig. 11    die Feldverteilung einer erfindungsgemäßen "gekröpften" Sattelspule in der xz-Ebene; und

Fig. 12    das berechnete Abbildungsverhalten des erfindungsgemäßen Gradientensystems in der xy-Ebene.

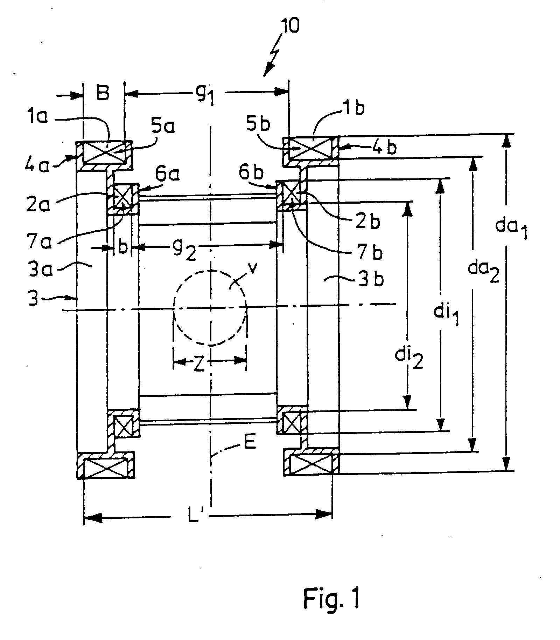

Das in der Fig. 1 dargestellte Hauptfeldspulensystem 10 umfaßt ein äußeres Paar von Wicklungen bzw. Feldspulen 1a und 1b sowie ein inneres Paar von Wicklungen bzw. Feldspulen 2a und 2b, welche entlang einer gemeinsamen zentralen Achse koaxial und bezüglich einer zentralen Quermittelebene E, welche rechtwinklig zu der zentralen Achse verläuft, insgesamt symmetrisch angeordnet sind. Die äußeren Wicklungen 1a und 1b sowie die inneren Wicklungen 2a und 2b sind auf einen insgesamt mit 3 bezeichneten Spulenkörper aufgewickelt, welcher zwei Tragringe 3a und 3b umfaßt, welche die jeweils einseitig von der Quermittelebene E angeordnete äußere und innere Wicklung 1a und 2a bzw. 1b und 2b tragen. Diese Tragringe 3a und 3b des Spulenkörpers 3 haben je ein äußeres, gemäß der Darstellung der Fig. 1 nach außen offenes, durch rechtwinklig aneinander anschließende Profilschenkel begrenztes U-Profil 4a bzw. 4b, durch deren in axialer Richtung gemessene lichte Breite B und durch deren in radialer Richtung gemessene Tiefe $(d_{a1}-d_{a2})/2$ die rechteckige Querschnittsfläche von Wickelkammern 5a bzw. 5b bestimmt ist, die von den Windungen der äußeren Feldspulen 1a bzw. 1b in dichtestmöglicher Packung eingenommen werden, wobei mit $d_{a1}$ der Außendurchmesser und $d_{a2}$ der Innendurchmesser der äußeren Wicklungen 1a bzw. 1b bezeichnet sind.

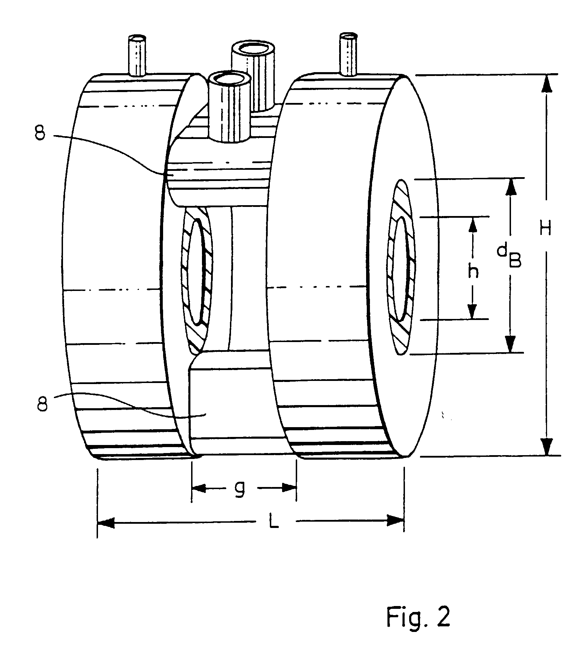

Des weiteren haben die Tragringe 3a und 3b je ein inneres, gemäß der Darstellung der Fig. 1 ebenfalls nach außen offenes, durch rechtwinklig aneinander anschließende Profilschenkel begrenztes U-Profil 6a bzw. 6b, durch deren in axialer Richtung gemessene lichte Breite b und deren in radialer Richtung gemessene Tiefe $(d_{i1}-d_{i2})/2$ die - ebenfalls rechteckige - Querschnittsfläche von Wickelkammern 7a bzw. 7b bestimmt ist, die von den Wicklungen der inneren Feldspulen 2a bzw. 2b - in dichtestmöglicher Packung - eingenommen wird, wobei mit $d_{i1}$ der Außendurchmesser und $d_{i2}$ der Innendurchmesser der inneren Wicklungen 2a bzw. 2b bezeichnet sind. Die Tragringe 3a und 3b der beiden Teilspulenpaare werden zweckmäßig aus separaten Teilringen zur Aufnahme je einer Wicklung 1a und 2a bzw. 1b und 2b gebildet. Nach dem Wickeln der Wicklungen werden die Teilringe zu je einem Tragring 3a bzw. 3b zusammengebaut und fest miteinander verbunden. Die solchermaßen gebildeten Tragringe 3a und 3b werden ihrerseits durch Längsbalken 8 fest miteinander verbunden, wobei, wie nicht eigens dargestellt, der axiale Abstand der Tragringe 3a und 3b justierbar ist. Bei dem in Fig. 2 dargestellten, bevorzugten Ausführungsbeispiel umfaßt der Spulenkörper 3 drei solcher Längsbalken, die symmetrisch zu der durch die Zeichenebene markierten, die zentrale Achse des Magnetsystems 10 enthaltenden Längsmittelebene angeordnet sind und dabei, entlang der senkrechten Achse gesehen, in gleichen Winkelabständen - axialsymmetrisch - um die Achse gruppiert sein können. Durch die Balken 8 werden die axialen Kräfte aufgefangen, welche die Wicklungen 1a und 1b sowie 2a und 2b im stromdurchflossenen Zustand des Magnetsystems aufeinander ausüben. Der axiale Abstand $g_1$, in dem die äußeren Wicklungen 1a und 1b voreinander angeordnet sind, kann bei dem Magnetsystem 10 zwischen 1/4 und 3/4 des inneren Spulendurchmessers $d_{a2}$ der äußeren Feldspulen 1a bzw. 1b variieren, wobei ein bevorzugter Wert dieses Abstandes $g_1$ bei etwa der Hälfte dieses inneren Spulendurchmessers $d_{a2}$ liegt.

Der axiale Abstand $g_1$, in welchem die beiden Wicklungen 1a und 1b des äußeren Spulenpaares voneinander angeordnet sind, kann zwischen 1/4 und 3/4 des inneren Durchmessers $d_{a2}$ des äußeren Spulenpaares 1a, 1b betragen und ist in spezieller Gestaltung dieses Spulenpaares etwa, d.h. mit einer Abweichung von ± 10% halb so groß wie der innere Spulendurchmesser $d_{a2}$. Damit liegen die Schwerpunkte der Querschnitte der Wicklungen 1a und 1b (axial ($g_1$ + B)/2, radial ($d_{a1}$ + $d_{a2}$)/2) axial weiter auseinander als bei einer Helmholtz-Anordnung dieses Wicklungspaars.

Das innere Spulenpaar 2a, 2b ist hinsichtlich seiner charakteristischen Abmessungen - Außendurchmesser $d_{i1}$ und Innendurchmesser $d_{i2}$ - kleiner als das äußere Spulenpaar 1a, 1b, wobei seine Wicklungsdichte dem Betrag nach derjenigen des äußeren Spulenpaares gleich ist. Bei Bedarf kann die Wicklungsdichte abweichend gewählt werden.

Der axiale Abstand $g_2$ der inneren Wicklungen 2a und 2b ist mit einer Abweichung von maximal 15% gleich dem axialen Abstand $g_1$ der äußeren Wicklungen 1a und 1b und beim dargestellten, speziellen Ausführungsbeispiel geringfügig kleiner als der axiale Abstand $g_1$ der äußeren Wicklungen 1a und 1b, so daß die axiale lichte Weite zwischen den beiden Wicklungen 2a und 2b ähnlich derjenigen zwischen den beiden äußeren Wicklungen 1a und 1b ist.

Der im Betrieb des Magnetsystems 10 durch das innere Paar von Wicklungen 2a, 2b fließende Strom ist, der Richtung nach, demjenigen entgegengesetzt, der durch das äußere Paar 1a, 1b fließt, so daß die von den beiden Wicklungspaaren 1a, 1b und 2a, 2b erzeugten Magnetfelder einander entgegengesetzt sind, wobei die Windungszahlen der äußeren Wicklungen 1a und 1b zu den Windungszahlen der inneren Wicklungen 2a und 2b - die gleiche Stromstärke in den Wicklungen 1a und 1b sowie 2a, 2b vorausgesetzt - im Verhältnis von etwa 4/1 zueinander stehen, wobei dieses Verhältnis innerhalb einer Marge von ± 20% variieren kann.

Durch geeignete Wahl der Stärke der Ströme, welche durch die beiden Wicklungspaare 1a, 1b sowie 2a, 2b fließen, läßt sich ein statisches Magnetfeld erzeugen, das innerhalb des in der Fig. 1 gestrichelt angedeuteten, kreisförmigen umrandeten Untersuchungsvolumens V, dessen Durchmesser mit Z bezeichnet ist, hinreichend homogen ist, wobei dieser Durchmesser Z zirka 40 cm beträgt (Feldabweichung 20 ppm).

In einer bevorzugten Gestaltung des Magnetsystems 10 mit supraleitenden Magnetspulen beträgt der axiale Abstand $g_1$ des äußeren Wicklungspaares 1a, 1b 887 mm und die axiale Breite B der Wickelkammern 220 mm. Die zwischen den Außenwänden der Wickelkammern 5a und 5b gemessene axiale Ausdehnung L' des Magnetsystems 10 beträgt 1327 mm. Der Innendurchmesser $d_{a2}$ der äußeren Wickelkammern 5a und 5b beträgt 1818 mm und der Außendurchmesser $d_{a1}$ der äußeren Wicklungen 1a und 1b 1997 mm. Die Windungsdichte in den äußeren Wickelkammern 5a und 5b beträgt 18,40 Windungen/cm².

Bei dem inneren Wicklungspaar 2a, 2b beträgt der axiale Abstand seiner Wickelkammern 7a und 7b 881,5 mm, wobei die axiale Breite b dieser Wickelkammern 7a und 7b jeweils 39,2 mm beträgt. Der Innendurchmesser $d_{i2}$ der Wicklungen 2a und 2b hat einen Wert von 1400 mm, während der Außendurchmesser $d_{i1}$ der inneren Wicklungen 2a und 2b einen Wert von 1507 mm hat. Die Windungsdichte der inneren Wicklungen 2a und 2b ist derjenigen der äußeren Wicklungen 1a und 1b entgegengesetzt und hat den Wert -46,73 Bei dem genannten Abstand $g_2$ der Wickelkammern 7a und 7b des inneren Spulenpaares 2a und 2b läßt sich ein supraleitendes Kryomagnetsystem aufbauen mit einem nutzbaren Zwischenraum z von 660 mm und einer Raumtemperaturbohrung mit einem Durchmesser von 1250 mm zur Aufnahme der erfindungsgemäßen Gradientenspulen.

Bei einer Stromstärke von 157 A ergibt sich ein homogenes Magnetfeld im Zentrum des Magnetsystems 10 von 0,5 Tesla.

Das bei diesem Hauptfeldmagneten bevorzugt verwendete Gradientenspulensystem enthält beispielsweise eine y-Transversalgradientenspule, bei der der axiale Abstand der zwei bezüglich der xy-Ebene spiegelbildlich gegenüberliegenden Teilspulen in z-Richtung 680 mm beträgt. Der Radius $r_2$ dieser der Lücke nächstgelegenen azimutalen Segmente beträgt 600 mm. Die Teilspule besitzt 27 Windungen aus Kupferdraht mit Rechteckquerschnitt (5,93 x 10 mm²) hochkant gewikkelt, so daß die azimutalen Segmente eine axiale Ausdehnung von 160 mm besitzen. Das andere azimutale Segment dieser Teilspulen besitzt einen Radius $r_1$ von 350 mm und einen Abstand zwischen der xy-Ebene und der dieser Ebene nächstgelegenen Windung von 540 mm. Beide azimutalen Segmente sind durch Leiterabschnitte miteinander verbunden, die in einem axialen Abstand von 520 mm von der xy-Ebene i.w. in radialer Richtung verlaufen. Die mittlere der 27 Windungen besitzt in beiden azimutalen Segmenten eine azimutale Ausdehnung von 120°.

Die Spule enthält ähnlich aufgebaute Kompensationsspulen mit Radien $r_1$ = 360 mm und $r_2$ = 600 mm, mit ebenfalls 27 Windungen, deren mittlere in den azimutalen Segmenten Abstände von der xy-Ebene von 620 mm bzw. 820 mm aufweist. Die verbindenden Leiterelemente beider azimutalen Segmente sind i.w. in einer zur xy-Ebene parallelen Ebene mit einem Abstand von 720 mm von der xy-Ebene i.w. in radialer Richtung angeordnet. Diese y-Gradientenspule erzeugt bei einer Stromstärke von 250 A ein homogenes Gradientenfeld mit einer Gradientenstärke von 14,25 milli Tesla/m.

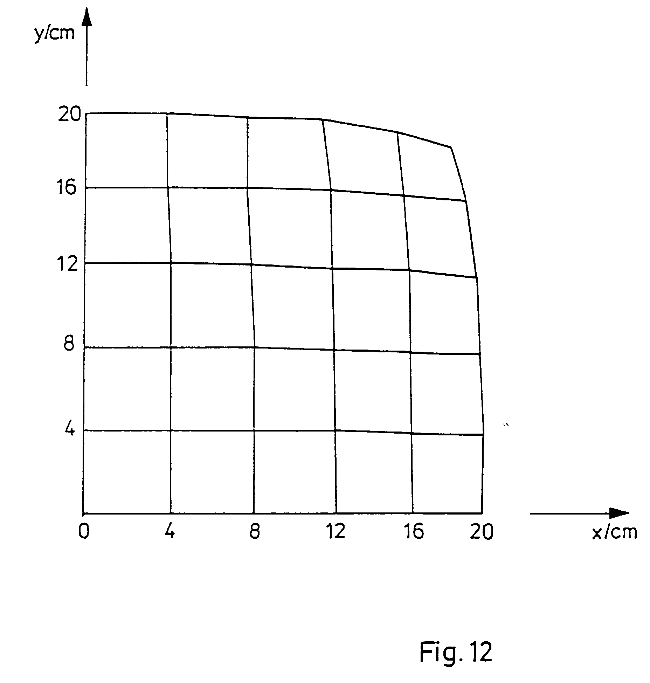

Bei diesen Abmessungen für die y-Gradientenspule und ähnlichen Abmessungen für die x-Gradientenspule läßt sich ein axialer freier Zugang für den Patienten im Gradientensystem von etwa 660 mm Durchmesser sowie ein transversaler Zugang von 660 mm Breite realisieren. Die gute Linearität der tesseralen Gradientenspulen wird durch die in Fig. 12 gezeigte Abbildung eines quadratischen Musters in der xy-Ebene veranschaulicht.

Die perspektivische Gesamtansicht einer Ausführungsform der erfindungsgemäßen NMR-Meßeinrichtung in Fig. 2 zeigt unter anderem die Gesamthöhe H der Apparatur, die vom Außendurchmesser des Kryostaten bestimmt wird, die Höhe h der horizontalen Patientenbohrung, die Breite g der seitlichen Zugriffslücke zum zentralen Untersuchungsvolumen und die Länge L der Gesamtapparatur.

Auf Details des ebenfalls in Fig. 2 dargestellten Kryosystems für die supraleitende Hauptfeldmagnetspule wird nicht näher eingegangen.

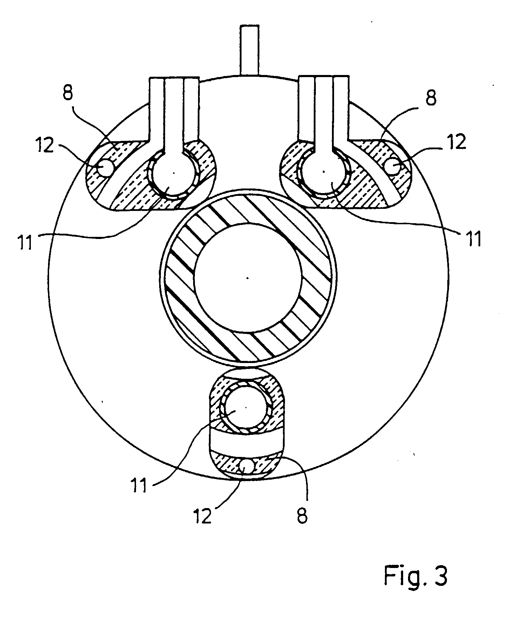

Fig. 3 zeigt einen Schnitt durch die seitliche Zugriffslücke der NMR-Meßeinrichtung senkrecht zur zentralen Achse. Durch die aufgeschnittenen Längsbalken 8 sind Verbindungsrohre 11 zwischen den beidseitigen Heliumtanks des die supraleitende Magnetspule enthaltenden Kryosystems sowie Verbindungsrohre 12 zwischen den die Heliumtanks umgebenden Tanks mit flüssigem Stickstoff zu sehen. Die üblicherweise vorhandenen Strahlungsschilde sind nicht eingezeichnet.

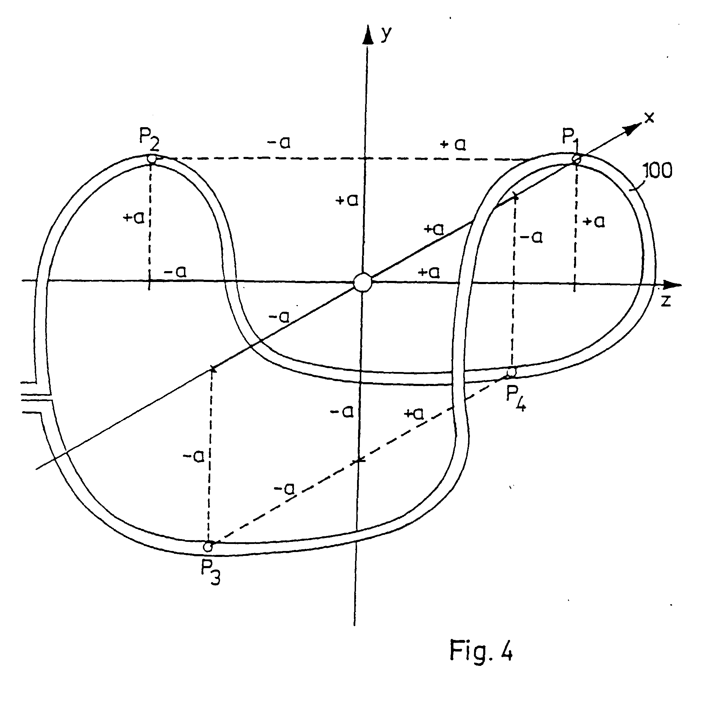

Die in Fig. 4 gezeigte YIN-YANG-HF-Spule 100, die bevorzugt bei dem erfindungsgemäßen NMR-System eingesetzt wird, ist (mit Ausnahme der Stromzuführungen) in sich geschlossen, sattelförmig um die z-Achse eines kartesischen Koordinatensystems, die mit der zentralen Achse des Hauptfeldmagneten 10 zusammenfällt, angeordnet, symmetrisch zur zy-Ebene und zur xy-Ebene, jedoch asymmetrisch zur zx-Ebene. Nach ihrem Einbau in die NMR-Meßeinrichtung umschließt sie das um den Koordinatenursprung angeordnete Meßvolumen.

Die YIN-YANG-Spule 100 erlaubt, wie aus Fig. 4 ersichtlich, einen besonders guten transversalen Zugriff auf einen längs der z-Achse im Homogenitätsvolumen liegenden Patienten. Dadurch, daß oberhalb der zx-Ebene keine störenden Querstege parallel zur z-Achse vorgesehen sind, hat die YIN-YANG-HF-Spule eine besonders große Transparenz.

Vorzugsweise liegen die in Fig. 4 dargestellten vier Extremalpunkte $P_1$ bis $P_4$ der HF-Spule ungefähr auf folgenden Koordinaten:

$$P_1: \qquad x_1 = 0 \qquad y_1 = + a \qquad z_1 = + a$$

$$P_2: \qquad x_2 = 0 \qquad y_2 = + a \qquad z_2 = - a$$

$$P_3: \qquad x_3 = - a \qquad y_3 = - a \qquad z_3 = 0$$

$$P_4: \qquad x_4 = + a \qquad y_4 = - a \qquad z_4 = 0$$

Dabei kann die Streckenlänge a zwischen 20 cm und 50 cm, vorzugsweise etwa bei 30 cm liegen.

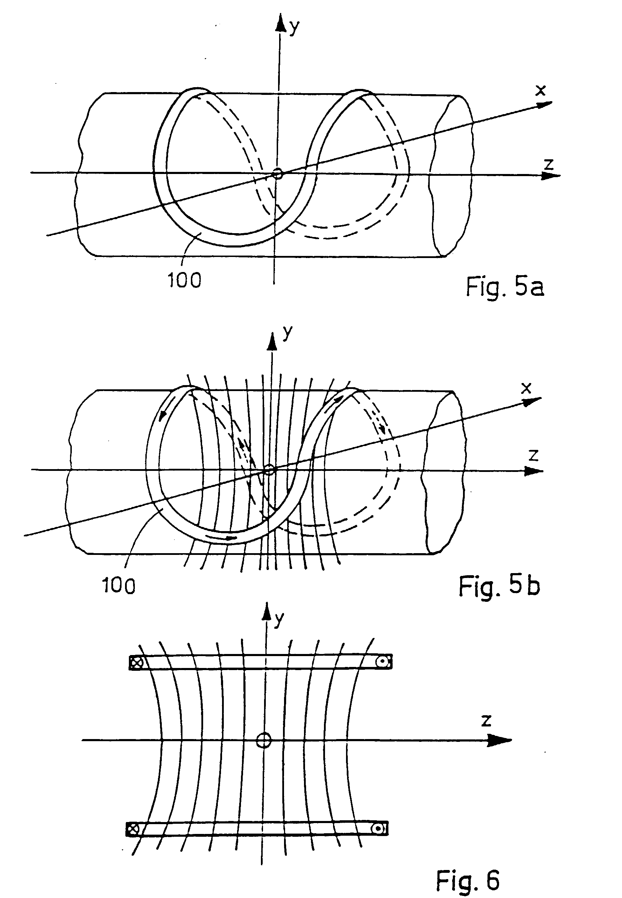

Die YIN-YANG-HF-Spule 100 kann entweder, wie in Fig. 4 gezeigt, eher eckige Konturen mit abgerundeten Kanten aufweisen, sie kann jedoch auch, wie in Fig. 5a gezeigt, im wesentlichen der Kontur eines Zylinders mit Radius a um die z-Achse folgen. Ein solcher Zylinder entspräche ziemlich genau der Zimmertemperaturbohrung in einem NMR-Kryostaten, durch welche der Patient in Richtung der z-Achse in den NMR-Tomographen eingeschoben wird.

Die in Fig. 5b auf der Spule 100 gezeigten Pfeile sollen eine mögliche Stromflußrichtung durch die Spule andeuten. Weiterhin sind in Fig. 5b die von der YIN-YANG-HF-Spule 100 erzeugten HF-Feldlinien angedeutet, die im Meßvolumen um den Koordinatenursprung herum im wesentlichen homogen verlaufen.

Die YIN-YANG-Spule 100 kann entweder aus Drähten, vorzugsweise Kupferdrähten von einer oder mehreren Wicklungen bestehen. Eine andere Möglichkeit ist die Verwendung eines in sich geschlossenen, elektrisch leitfähigen Bandes, vorzugsweise aus Kupferblech, zur Herstellung der YIN-YANG-HF-Spule 100 nach Art einer sogenannten "Stream-line-Spule".

Fig. 6 zeigt zum Vergleich eine Helmholtz-artige HF-Spule nach dem Stand der Technik, bestehend aus zwei Teilspulen oberhalb und unterhalb der zx-Ebene symmetrisch zum Koordinatenursprung. Außerdem sind die von dieser bekannten Spule erzeugten HF-Feldlinienverläufe angedeutet. Wie man deutlich sieht, ist ein transversaler Zugriff mit dieser bekannten Anordnung zwar möglich, jedoch behindert die obere Teilspule in jedem Fall den Zugriff eines Operateurs von schräg oben.

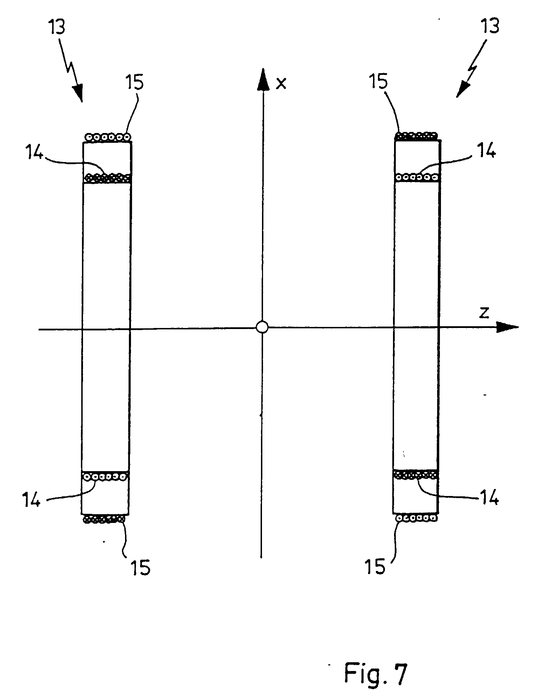

Zur Erzeugung eines Gradientenfeldes in Richtung der z-Achse wird das in Fig. 7 in einer Schnittansicht gezeigte abgeschirmte z-Gradientenspulensystem 13 vorgeschlagen. Die bezüglich der xy-Ebene symmetrischen Teilspulensysteme sind gegenläufig gewickelt, wobei die radial inneren z-Gradientenfeldwicklungen 14 wiederum gegenläufig zu den zugehörigen radial äußeren schirmspulenwicklungen 15 gewickelt sind. Vorzugsweise weisen die z-Gradientenfeldwicklungen 14 um den Faktor $(r_4/r_3)^2$ mehr Windungen auf als die Abschirmspulenwicklungen 15.

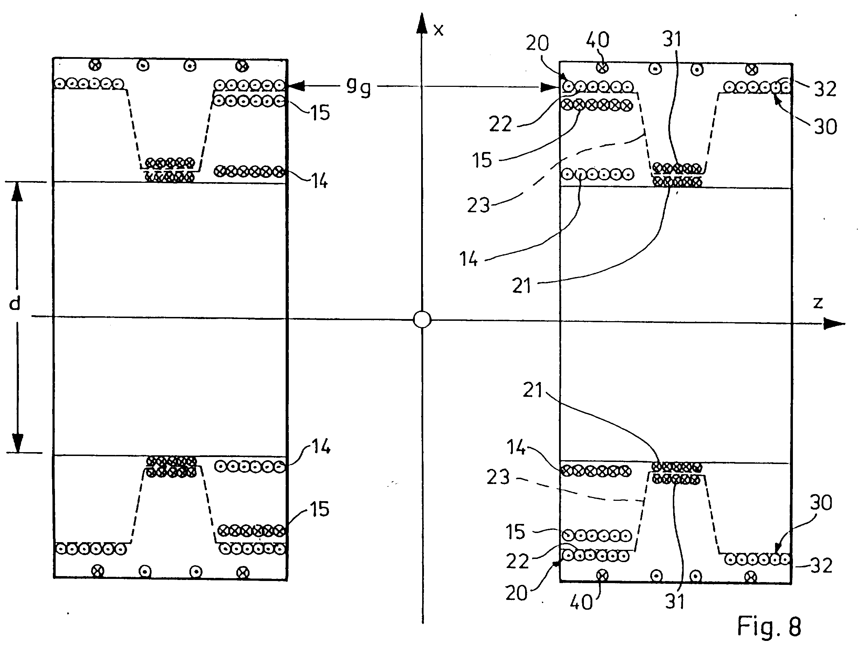

Fig. 8 zeigt einen Schnitt durch das erfindungsgemäße Gradientenspulensystem in der axialen Bohrung des Hauptfeldmagneten in der xz-Ebene. Das gezeigte System enthält vier Teilspulen 20, die symmetrisch zum Koordinatenursprung angeordnet sind. Die vier Teilspulen 20 in Fig. 8 erzeugen zusammen ein im Untersuchungsvolumen um den Koordinatenursprung herum im wesentlichen konstanten Gradienten der axialen magnetischen Feldkomponente in Richtung der x-Achse. In der Zeichnung nicht dargestellt ist ein um 90° um die z-Achse gegenüber dem gezeigten x-Gradientensystem verdrehtes y-Gradientensystem, das ansonsten den gleichen Aufbau wie das gezeigte x-Gradientensystem aufweist.

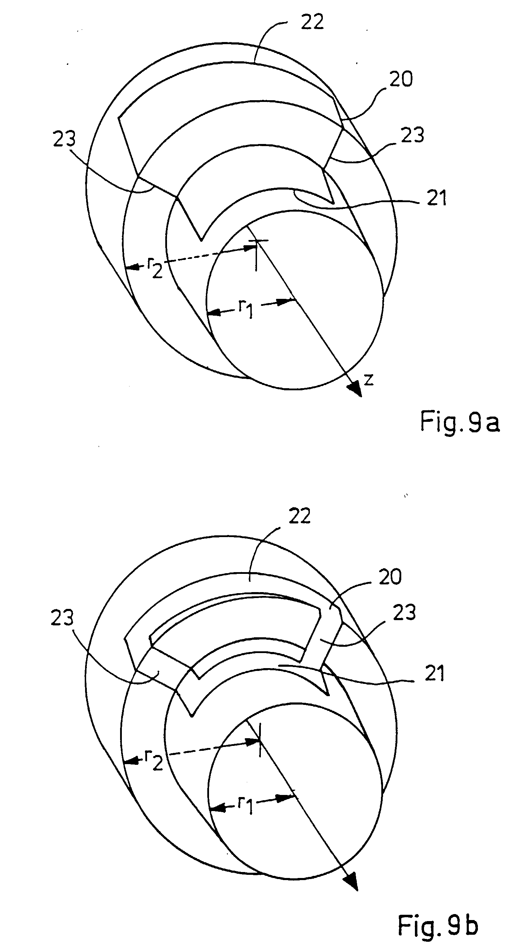

Die Teilspulen 20 des tesseralen Gradientensystems sind sattelartig ausgeführt, wie in Fig. 9a und 9b zu erkennen ist. Die einzelnen Teilspulen 20 weisen jeweils zwei in azimutaler Richtung um die z-Achse verlaufende, elektrisch leitfähige Segmente 21, 22 auf, von denen das radial innere Segment 21 einen Abstand $r_1$ und das radial äußere Segment 22 einen Abstand $r_2$ von der z-Achse aufweist. Die beiden Segmente 21, 22 sind axial bezüglich der z-Achse beabstandet, wobei das radial äußere Segment 22 näher am Koordinatenursprung angeordnet ist als das radial innere Segment 21. Die beiden Segmente 21, 22 sind durch Leiterabschnitte 23 miteinander verbunden.

Die Teilspulen 20 können, wie in Fig. 9a gezeigt, aus Drähten, vorzugsweise Kupferdrähten, oder wie in Fig. 9b gezeigt, aus elektrisch leitfähigen Bändern aufgebaut sein. Eine weitere Möglichkeit besteht darin, die Teilspulen 20 als Stream-line-Spulen aufzubauen.

Bei den in Fig. 9a und 9b gezeigten Ausführungsformen liegen die Segmente 21, 22 der Teilspulen 20 auf Zylinderoberflächen um die z-Achse. In nicht dargestellten Ausführungsformen können die Segmente allerdings auch auf Kegeloberflächen liegen, die sich zum Koordinatenursprung hin öffnen.

Zur Kompensation der bei Stromfluß durch die Teilspule 20 hervorgerufenen Drehmomente sind, wie in Fig. 8 gezeigt, Kompensationsspulen 30 vorgesehen, die im wesentlichen in ihrem Aufbau den Teilspulen 20 ähneln. Insbesondere weisen die Kompensationsspulen 30 auch azimutale innere Segmente 31 und azimutale äußere Segmente 32 auf, die einen größeren radialen Abstand von der z-Achse besitzen, als die inneren Segmente 31.

Die Kompensationsspule 30 im dargestellten Ausführungsbeispiel ist mit ihrem azimutal inneren Segment 31 von der z-Achse aus gesehen radial außerhalb des radial inneren Segments 21 der Teilspule 20 angeordnet. In Richtung der z-Achse überdecken sich die beiden Segmente 21, 31 in axialer Richtung. Der Wicklungssinn der radial inneren Segmente 21, 31 und der radial äußeren Segmente 22, 32 ist jeweils der gleiche. Die Windungszahl der Kompensationsspule 30 ist geringer als die der Teilspule 20, während die axialen Erstreckungen in Richtung der z-Achse bei beiden Spulen die gleichen sind.

Wie aus Fig. 8 ersichtlich, ist um jeweils zwei axial bezüglich der z-Achse gegenüberliegende Teilspulen 20 herum eine Abschirmspule 40 um die z-Achse gewickelt, deren Radius $R_2$ größer als der radiale Abstand $r_2$ der äußeren Segmente 22 von der z-Achse ist. Die axiale Ausdehnung der Abschirmspule 40 bezüglich der z-Achse entspricht dem geringsten axialen Abstand der Teilspule 20 und dem größten axialen Abstand der Kompensationsspule 30 vom Koordinatenursprung. Mit anderen Worten überdeckt die Abschirmspule 40 die Kombination aus Teilspule 20 und Kompensationsspule 30 axial vollständig. Die Abschirmspule 40 dient der Unterdrückung der restlichen Radialkomponenten des von der Spulenkombination 20, 30 erzeugten Magnetfeldes.

Schließlich ist in Fig. 8 nochmals das in Fig. 7 gezeigte abgeschirmte z-Gradientenspulensystem 13 mit den radial inneren z-Gradientenfeldwicklungen 14 und den radial äußeren Abschirmspulenwicklungen 15 dargestellt. Es ist radial bezüglich der z-Achse innerhalb der radial äußeren Segmente 22 der Teilspulen 20 platzsparend angeordnet.

Sämtliche Gradienten-, Kompensations-, und Abschirmspulen 14, 15, 20, 30, 40 sind in einem Tragekörper mit Kunststoff derart vergossen, daß eine axiale Bohrung mit dem Durchmesser d um die z-Achse offenbleibt, die zur Aufnahme eines Menschen in das erfindungsgemäße NMR-Tomographiesystem geeignet ist.

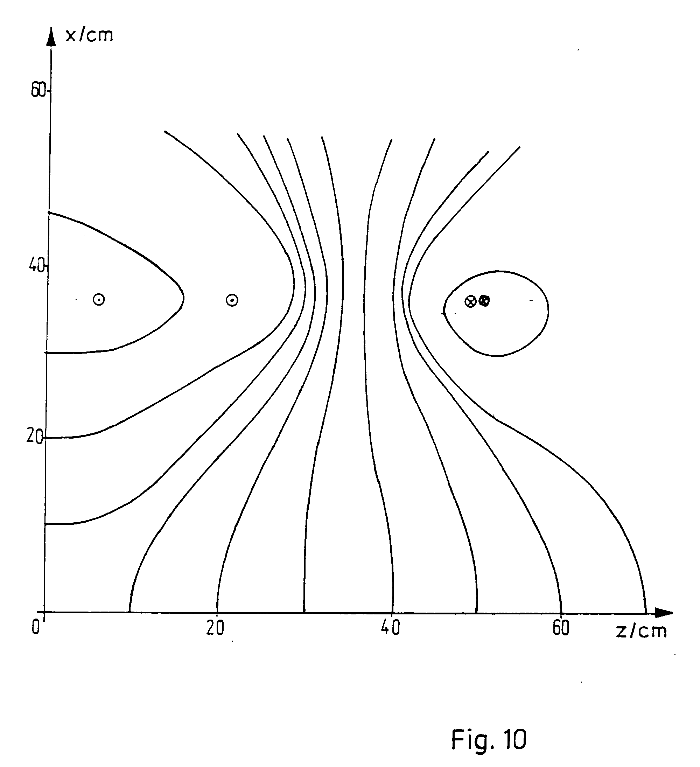

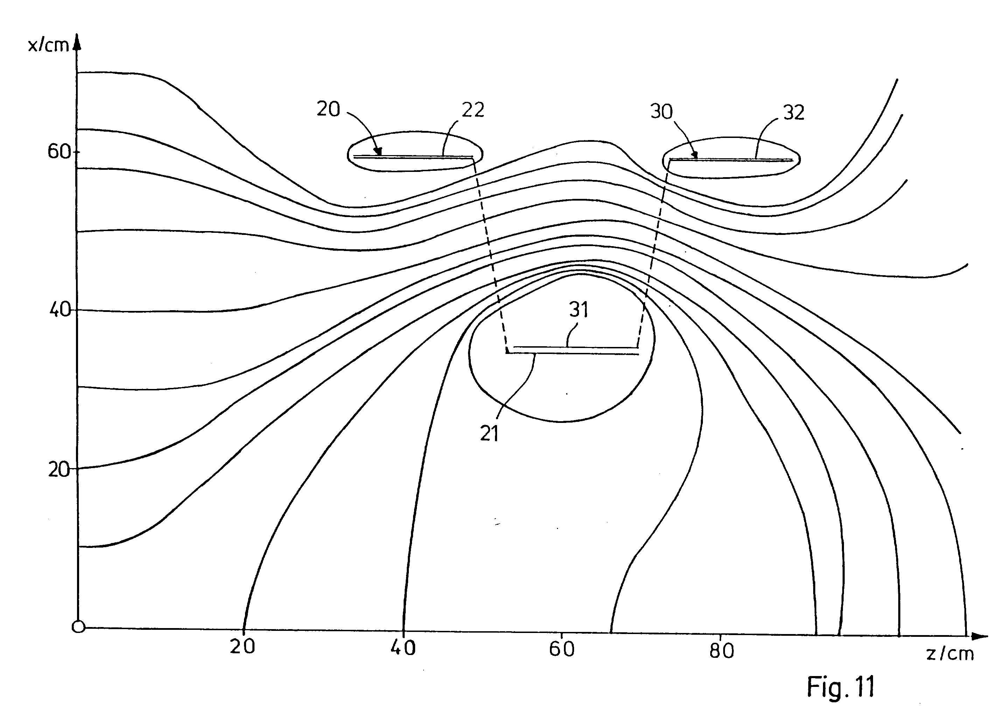

Die Figuren 10 und 11 zeigen berechnete Feldlinienverläufe in der xz-Ebene. Fig. 10 zeigt den berechneten Feldlinienverlauf für eine klassische asymmetrische Sattelspule, wobei auf der linken Seite die auseinanderliegenden Segmente und auf der rechten Seite die näher zusammenliegenden Rückführungssegmente der Sattelspule angedeutet sind. Wie man sieht, ergibt sich bei z = 0 ein halbwegs linearer Gradientenfeldverlauf, während bei z ≈ 38 cm starke radial von der z-Achse nach außen parallel zur x-Achse verlaufende Feldlinien auftreten, die in den umgebenden Metallteilen, insbesondere in der Außenhaut der statengefäße zu starken Wirbelströmen Veranlassung geben. Außerdem wird in Fig. 10 noch einmal deutlich, daß die klassische asymmetrische Sattelspule ziemlich nahe an die xy-Ebene herankommt, und damit äußerst störend in die seitliche Zugriffslücke hineinragt.

In Fig. 11 ist eine berechnete Feldlinienverteilung der Kombination aus einer erfindungsgemäßen "gekröpften" Teilspule 20 und einer zugehörigen Kompensationsspule 30 in der xz-Ebene dargestellt. Wie man sieht, ergibt sich bei z = 0 eine ähnlich lineare Gradientenfeldverteilung wie bei der in Fig. 10 gezeigten klassischen asymmetrischen Sattelspule. Deutlich ist jedoch zu erkennen, daß ein seitlicher Zugriff in einer axialen Länge vom Ursprung bis zur Koordinate z = 34 cm ungehindert möglich ist. Außerdem erzeugt die Spulenkombination 20, 30 kaum schädliche Radialfeldkomponenten. Die restlichen parasitären Radialanteile des erzeugten Gradientenfeldes können ohne weiteres durch die Abschirmspule 40, die in die der Fig. 11 zugrundeliegende Berechnung nicht einbezogen wurde, kompensiert werden.

Wie Fig. 11 deutlich macht, tragen wesentlich zum Feld im Untersuchungsvolumen hauptsächlich die dem Koordinatenursprung am nächsten gelegenen radial äußeren Segmente 22 bei. Zum Erreichen hoher Gradientenstärken bei guter Linearität im Meßvolumen ist es wichtig, daß diese radial äußeren Segmente 22 einen möglicht großen radialen Abstand $r_2$ von der z-Achse besitzen.

Fig. 12 schließlich zeigt das Abbildungsverhalten einer erfindungsgemäßen x-Gradientenspule in der xy-Ebene. Wie man sieht, treten Verzerrungen des dargestellten quadratischen Gitternetzes erst in relativ großen Abständen vom Koordinatenursprung auf.

Das oben beschriebene erfindungsgemäße NMR-Tomographiesystem ermöglicht aufgrund des ungehinderten seitlichen Zugriffs auf das Untersuchungsvolumen völlig neue Arbeitsmöglichkeiten für Mediziner im diagnostischen und chirurgischen Bereich.

**Patentansprüche**

1. Kernspinresonanz (NMR)-Meßeinrichtung, insbesondere NMR-Tomographiegerät, mit einer vorzugsweise supraleitenden Hauptfeldspule, die in einem Meßvolumen, dessen Zentrum mit einem Koordinatenursprung eines kartesischen x-, y-, z-Koordinatensystems zusammenfällt, ein homogenes statisches Magnetfeld $B_0$ in Richtung der z-Achse des Koordinatensystems erzeugen kann, und mit einem tesseralen Gradientenspulensystem zur Erzeugung magnetischer Gradientenfelder mit im Meßvolumen i.w. linearem Verlauf in einer Richtung senkrecht zur z-Achse, wobei das Gradientenspulensystem aus mindestens vier i.w. gleichen, symmetrisch mit radialem und axialem Abstand zum Koordinatenursprung angeordneten, sattelartigen Teilspulen besteht, die jeweils zwei in azimutaler Richtung um die z-Achse verlaufende, elektrisch leitfähige Segmente aufweisen, von denen ein Segment einen möglichst geringen radialen Abstand $r_1$ und das andere Segment einen möglichst großen radialen Abstand $r_2$ von der z-Achse hat, wobei die beiden azimutalen Segmente einen axialen Abstand voneinander in Richtung der z-Achse aufweisen, durch Leiterabschnitte (23) miteinander verbunden sind und sich gemeinsam auf einer rotationssymmetrischen oder ellipsoiden Fläche r(z) befinden, wobei jede Teilspule (20) mehrere Windungen aufweist,
dadurch gekennzeichnet, daß
das radial äußere Segment (22) mit dem radialen Abstand $r_2$ von der z-Achse axial bezüglich der z-Achse näher am Koordinatenursprung angeordnet ist als das radial innere Segment (21) mit dem radialen Abstand $r_1$ von der z-Achse, und daß der im wesentlichen von der Hauptfeldspule (10) gebildete Hauptfeldmagnet eine Raumtemperaturbohrung mit Durchmesser $d_B$ sowie eine Lücke g in axialer Richtung um den Koordinatenursprung aufweist, wobei gilt: $1{,}6\, g \leq d_B \leq 2{,}1\, g$.

2. NMR-Meßeinrichtung nach Anspruch 1, dadurch gekennzeichnet, daß der axiale Abstand $g_g$ zweier bezüglich der xy-Ebene spiegelbildlich gegenüberliegender Teilspulen (20) in z-Richtung ungefähr gleich der Breite der Lücke g ist.

3. NMR-Meßeinrichtung nach Anspruch 2, dadurch gekennzeichnet, daß $2 \cdot r_2$ wenig kleiner ist als $d_B$.

4. NMR-Meßeinrichtung nach einem der vorhergehenden Ansprüche, dadurch gekennzeichnet, daß der Wert des radialen Abstandes $2 \cdot r_1$ der der z-Achse nächstgelegenen azimutalen Segmente (21) nur wenig größer als der Durchmesser eines hypothetischen Zylinders ist, der einem Patienten im NMR-Tomographiegerät während einer Untersuchung ausreichend Platz bietet.

5. NMR-Meßeinrichtung nach einem der vorhergehenden Ansprüche, dadurch gekennzeichnet, daß die radial äußeren Segmente (22) auf einer Zylinderoberfläche mit dem Radius $r_2$ und die radial inneren Segmente (21) auf einer koaxialen Zylinderoberfläche mit dem Radius $r_1$ liegen.

6. NMR-Meßeinrichtung nach einem der Ansprüche 1 bis 4, dadurch gekennzeichnet, daß die Segmente (21, 22) jeweils auf einer sich zum Koordinatenursprung hin öffnenden Kegeloberfläche liegen.

7. NMR-Meßeinrichtung nach Anspruch 6, dadurch gekennzeichnet, daß die äußeren und die inneren Segmente (21, 22) jeweils auf der gleichen Kegeloberfläche liegen.

8. NMR-Meßeinrichtung nach einem der vorhergehenden Ansprüche, dadurch gekennzeichnet, daß für jede Teilspule (20) eine Kompensationsspule (30) vorgesehen ist, die im axialen Bereich des radial inneren Segments (21) der Teilspule (20) ein azimutales inneres Segment (31) mit einem radialen Abstand $r_1'$ von der z-Achse aufweist, der von dem radialen Abstand $r_1$ des radial inneren Segments (21) der Teilspule (20) geringfügig, vorzugsweise etwa um die radiale Dicke des Segments (21) verschieden ist.

9. NMR-Meßeinrichtung nach Anspruch 8, dadurch gekennzeichnet, daß die Kompensationsspule (30) ein zweites azimutales Segment (32) aufweist, das axial in z-Richtung vom Koordinatenursprung weiter beabstandet ist als das erste azimutale Segment (31) der Kompensationsspule (30), und das einen radialen Abstand $r_2'>r_1'$ von der z-Achse hat.

10. NMR-Meßeinrichtung nach einem der Ansprüche 8 oder 9, dadurch gekennzeichnet, daß $r_2' \approx r_2'$, vorzugsweise $r_2' = r_2$.

11. NMR-Meßeinrichtung nach einem der Ansprüche 8 bis 10, dadurch gekennzeichnet, daß die Kompensationsspule (30) eine andere Windungszahl als die Teilspule (20) hat.

12. NMR-Meßeinrichtung nach einem der Ansprüche 8 bis 11, dadurch gekennzeichnet, daß die maximale axiale Erstreckung in Richtung der z-Achse bei der Teilspule (20) und der Kompensationsspule (30) etwa die gleiche ist.

13. NMR-Meßeinrichtung nach einem der Ansprüche 8 bis 12, dadurch gekennzeichnet, daß um jeweils zwei axial bezüglich der z-Achse gegenüberliegende Teilspulen (20) herum auf der Oberfläche eines Zylinders um die z-Achse mit einem Radius $R_2 \geq r_2$ und einer axialen Ausdehnung in z-Richtung, die ungefähr der axialen Ausdehnung der Hauptfeldspule (10) ausschließlich der Lücke g entspricht, angeordnete Abschirmspulen (40) vorgesehen sind.

14. NMR-Meßeinrichtung nach Anspruch 13, dadurch gekennzeichnet, daß die Windungen der Abschirmspulen (40) mit den Windungen der entprechenden Teilspulen (20) in Reihe geschaltet sind.

15. NMR-Meßeinrichtung nach Anspruch 13 oder 14, dadurch gekennzeichnet, daß die Zahl der Windungen der Abschirmspulen (40) kleiner als die Zahl der Windungen der entsprechenden Teilspulen (20) ist.

16. NMR-Meßeinrichtung nach einem der vorhergehenden Ansprüche, dadurch gekennzeichnet, daß die Spulen (20, 30, 40) aus Windungen von Drähten, vorzugsweise Kupferdrähten bestehen.

17. NMR-Meßeinrichtung nach einem der Ansprüche 1 bis 15, dadurch gekennzeichnet, daß die Spulen (20, 30, 40) zumindest teilweise aus in sich geschlossenem Band, vorzugsweise aus Kupferblech bestehende Stream-line-Spulen sind.

18. NMR-Meßeinrichtung nach einem der vorhergehenden Ansprüche, dadurch gekennzeichnet, daß zwei um 90° um die z-Achse gegeneinander versetzte Sätze von aus jeweils vier Teilspulen (20) bestehende x- bzw. y-Gradientenspulen vorgesehen sind.

19. NMR-Meßeinrichtung nach einem der vorhergehenden Ansprüche, dadurch gekennzeichnet, daß ein abgeschirmtes z-Gradientenspulensystem (13) zur Erzeugung magnetischer Gradientenfelder mit im Meßvolumen i.w. linearem Verlauf in einer Richtung parallel zur z-Achse vorgesehen ist, welches aus zwei bezüglich der xy-Ebene spiegelbildlich angeordneten, zylindrischen Wicklungspaaren um die z-Achse mit jeweils einer radial inneren z-Gradientenfeldwicklung (14) und einer radial äußeren Abschirmspulenwicklung (15) besteht.

20. NMR-Meßeinrichtung nach Anspruch 19, dadurch gekennzeichnet, daß die zylindrischen Wicklungspaare im axialen Bereich der radial äußeren azimutalen Segmente (22) angeordnet sind, wobei der radiale Abstand $r_4$ der Abschirmspulenwicklung (15) kleiner als der radiale Abstand $r_2$ des radial äußeren Segments (22) ist.

21. NMR-Meßeinrichtung nach Anspruch 19 oder 20, dadurch gekennzeichnet, daß die z-Gradientenfeldwicklung (14) ungefähr das $(r_4/r_3)^2$-fache an Windungen aufweist wie die Abschirmspulenwicklung (15), wobei $r_3$ der radiale Abstand der z- Gradientenfeldwicklung (14) von der z-Achse ist.

22. NMR-Meßeinrichtung nach einem der vorhergehenden Ansprüche, dadurch gekennzeichnet, daß die Gradientenspulen (14, 20) und ggf. auch die Kompensations- (30), Abschirm- (15) und Zylinderspulen (40) in einem Tragekörper mit Kunststoff vergossen sind, so daß eine axiale Bohrung um die z-Achse offen bleibt, die zur Aufnahme eines Menschen geeignet ist.

23. NMR-Meßeinrichtung nach Anspruch 22, dadurch gekennzeichnet, daß ein axial in die axiale Bohrung des Tragekörpers oder transversal in die Lücke g des Hauptfeldmagneten einschiebbares Hochfrequenz (HF)-Spulensystem zur Erzeugung eines im Meßvolumen i.w. homogenen HF-Feldes in Richtung der x- und/oder der y-Achse vorgesehen ist.

24. NMR-Meßeinrichtung nach Anspruch 23, dadurch gekennzeichnet, daß das HF-Spulensystem aus einer sattelförmig um die z-Achse angeordneten, symmetrisch zur zy-Ebene und zur xy-Ebene, jedoch asymmetrisch zur zx-Ebene verlaufenden, in sich geschlossenen HF-Spule (100) besteht.

25. NMR-Meßeinrichtung nach Anspruch 24, dadurch gekennzeichnet, daß die HF-Spule (100) vier Extremalpunkte $P_1$ bis $P_4$ in Richtung der y-Achse mit den ungefähren, vorzugsweise den exakten Koordinaten

$$P_1: x_1 = 0 \qquad y_1 = + a \qquad z_1 = + a$$

$$P_2: x_2 = 0 \qquad y_2 = + a \qquad z_2 = - a$$

$$P_3: x_3 = - a \qquad y_3 = - a \qquad z_3 = 0$$

$$P_4: x_4 = + a \qquad y_4 = - a \qquad z_4 = 0$$

aufweist, wobei a jeweils die gleiche bestimmte Streckenlänge bezeichnet.

26. NMR-Meßeinrichtung nach Anspruch 25, dadurch gekennzeichnet, daß a zwischen 20 cm und 50 cm, vorzugsweise etwa 30 cm beträgt.

27. NMR-Meßeinrichtung nach einem der Ansprüche 23 bis 26, dadurch gekennzeichnet, daß die HF-Spule (100) aus Drähten, vorzugsweise Kupferdrähten, von einer oder mehreren Wicklungen besteht.

28. NMR-Meßeinrichtung nach einem der Ansprüche 23 bis 26, dadurch gekennzeichnet, daß die HF-Spule (100) eine aus einem in sich geschlossenen leitfähigen Band, vorzugsweise aus Kupferblech bestehende Stream-line-Spule ist.

29. NMR-Meßeinrichtung nach einem der Ansprüche 23 bis 28, dadurch gekennzeichnet, daß die Spule (100) i.w. der Kontur eines Zylinders um die z-Achse folgt.

30. NMR-Meßeinrichtung nach einem der vorhergehenden Ansprüche, dadurch gekennzeichnet, daß die Hauptfeldspule (10) ein Paar untereinander gleicher radial äußerer Feldspulen aufweist, die auf einer gemeinsamen Achse mit einem axialen Abstand ($g_1$) zueinander angeordnet sind, sowie ein Paar radial innerer, mit den äußeren Feldspulen koaxialer Feldspulen, die ebenfalls untereinander gleich sind, wobei beide Spulenpaare symmetrisch zu einer zentralen, zur gemeinsamen Achse senkrecht verlaufenden Mittelebene (E) angeordnet sind und - im Betrieb des Magnetsystems (10) - die Stromrichtung in den inneren Feldspulen (2a und 2b) zu derjenigen in den äußeren Feldspulen (1a und 1b) entgegengesetzt gerichtet ist, und wobei der axiale Abstand ($g_1$) der äußeren Feldspulen (1a und 1b) im Bereich zwischen 1/4 und 3/4, vorzugsweise etwa 1/2 des Innendurchmessers ($d_{a2}$) der äußeren Feldspulen (1a und 1b) beträgt, und daß der axiale Abstand ($g_2$) der inneren Feldspulen (2a und 2b) mit einer Abweichung von maximal 15% gleich dem axialen Abstand ($g_1$) der äußeren Feldspulen (1a und 1b) ist, wodurch ein Öffnungswinkel für eine transversale Zugangsöffnung zum Untersuchungsvolumen definiert ist, die sich quer zur Richtung des homogenen Magnetfeldes erstreckt und zwischen den inneren Feldspulen (1a, 2b) verläuft.

31. NMR-Meßeinrichtung nach Anspruch 30, dadurch gekennzeichnet, daß zur Rückführung des Magnetflusses eine das Feldspulensystem (1a, 1b, 2a, 2b) außenseitig, in Umfangsrichtung gesehen mindestens abschnittsweise umgebende Eisenabschirmung vorgesehen ist, daß die Eisenabschirmung einen das Spulensystem (1a, 1b, 2a, 2b) umgebenden rohrförmigen Mantelkörper aufweist, und daß der Mantelkörper mindestens eine Aussparung hat, deren parallel zur zentralen Achse gemessene longitudinale und rechtwinklig dazu gemessene azimutale lichte Weite durch die entsprechenden Abmessungen einer transversalen Zugangsöffnung des Magnetsystems (10) bestimmt sind.

32. NMR-Meßeinrichtung nach Anspruch 31, dadurch gekennzeichnet, daß die Eisenabschirmung parallel zur zentralen Achse des Spulensystems (1a, 1b, 2a, 2b) sich erstreckende balkenförmige Abschirmelemente umfaßt, deren in Umfangsrichtung gemessener Abstand durch die Öffnungsweite transversaler Zugangsöffnungen bestimmt ist.

33. NMR-Meßeinrichtung nach Anspruch 32, dadurch gekennzeichnet, daß die Eisenabschirmung mindestens drei balkenförmige Abschirmelemente umfaßt.

34. NMR-Meßeinrichtung nach Anspruch 32 oder 33, dadurch gekennzeichnet, daß die balkenförmigen Abschirmelemente axialsymmetrisch bezüglich der zentralen Achse angeordnet sind.

35. NMR-Meßeinrichtung nach einem der Ansprüche 31 bis 34, dadurch gekennzeichnet, daß die Eisenabschirmung ringscheibenförmige Endstirnwände hat.

**Claims**

1. Nuclear spin resonance (NMR) measuring device, in particular NMR tomography apparatus with a preferentially superconducting main field coil which, in a measuring volume whose center coincides with a coordinate origin of a Cartesian x, y, z coordinate system, can produce a homogeneous static magnetic field $B_0$ in the direction of the z-axis of the coordinate system, and with a tesseral gradient coil system for the production of magnetic gradient fields with largely linear dependence, in a direction perpendicular to the z-axis, within the measuring volume, whereby the gradient coil system consists of at least four largely equal, saddle-like partial coils which are arranged symmetrically with radial and axial separations from the coordinate origin, the partial coils each exhibiting two electrically conducting segments which run in the azimuthal direction about the z-axis, one segment of which has as small a radial separation $r_1$ and the other segment as large a radial separation $r_2$ as possible from the z-axis, the two azimuthal segments exhibiting an axial separation from each other in the direction of the z-axis, being connected to each other via conducting sections (23) and being located on a common rotationally symmetric or ellipsoidal surface r(z), wherein each partial coil (20) comprises several windings, characterized in that the radially outer segment (22) with the radial separation $r_2$ from the z-axis is, with respect to the z-axis, axially closer to the coordinate origin than the radially inner segment (21) with the radial separation $r_1$ from the z-axis and that the main field magnet, which is formed largely by the main field coil (10), exhibits a room temperature bore with a diameter $d_B$ as well as a gap g in the axial direction about the coordinate origin whereby: $1.6 \, g \leq d_B \leq 2.1 \, g$.

2. NMR measuring device according to claim 1, characterised in that the axial separation gg in the z-direction of two partial coils (20) which lie mirror-symmetrically to the xy-plane opposite to each other is approximately equal to the width of the gap g.

3. NMR measuring device according to claim 2, characterised in that 2 $r_2$ is slightly smaller than $d_B$.

4. NMR measuring device according to one of the preceding claims, characterised in that the value of the radial separation 2 $r_1$ of the azimuthal segments (21) in closest proximity to the z-axis is only slightly larger than the diameter of a hypothetical cylinder offering sufficient space to a patient in the NMR tomography apparatus during the course of an examination.

5. NMR measuring device according to one of the preceding claims, characterised in that the radially outer segments (22) lie on a cylinder surface of radius $r_2$ and the radially inner segments (21) on a coaxial cylinder surface of radius $r_1$.

6. NMR measuring device according to one of the claims 1 to 4, characterised in that the segments (21, 22) each lie on the surface of a cone which opens towards the coordinate origin.

7. NMR measuring device according to claim 6, characterised in that the outer and the inner segments (21, 22) each lie on the same conic surface.

8. NMR measuring device according to one of the preceding claims, characterised in that, for each partial coil (20), a compensation coil (30) is provided which, in the axial vicinity of the radially inner segment (21) of the partial coil (20), exhibits an azimuthal inner segment (31) with a radial separation $r_1'$ from the z-axis which deviates only slightly from

the radial separation $r_1$ of the radially inner segment (21) of the partial coil (20), preferably by approximately the radial thickness of the segment (21).

9. NMR measuring device according to claim 8, characterised in that the compensation coil (30) exhibits a second azimuthal segment (32) which is further separated axially in the z-direction from the coordinate origin than the first azimuthal segment (31) of the compensation coil (30) and which has a radial separation $r_2'>r_1'$ from the z-axis.

10. NMR measuring device according to one of the claims 8 or 9, characterised in that $r_2' \approx r_2'$, preferentially, $r_2' = r_2$.

11. NMR measuring device according to one of the claims 8 through 10, characterised in that the compensation coil (30) has a different number of windings than the partial coil (20).

12. NMR measuring device according to one of the claims 8 through 11, characterised in that the maximum axial extent of the partial coil (20) and the compensation coil (30) in the direction of the z-axis is approximately the same.

13. NMR measuring device according to one of claims 8 through 12, characterised in that shielding coils (40) are provided for, which are arranged about two partial coils (20) each, the partial coils (20) lying axially across from each other with respect to the z-axis and the shielding coils (40) being arranged on the surface of a cylinder about the z-axis with a radius $R_2 \geq r_2$ and having an axial extent in the z-direction which is approximately equal to the axial extent of the main field coil (10) excluding the gap g.

14. NMR measuring device according to claim 13, characterised in that the windings of the shielding coils (40) are connected in series with the windings of the corresponding partial coils (20).

15. NMR measuring device according to claim 13 or 14, characterised in that the number of windings of the shielding coils (40) is smaller than the number of windings of the corresponding partial coils (20).

16. NMR measuring device according to one of the previous claims, characterised in that the coils (20, 30, 40) consist of windings from wires, preferentially copper wires.

17. NMR measuring device according to one of the claims 1 to 15, characterised in that the coils (20, 30, 40) are, at least partially, comprised of streamline coils made from a closed band, preferentially out of copper sheet metal.

18. NMR measuring device according to one of the preceding claims, characterised in that two sets of x-, y-gradient coils are provided for, which are displaced relative to each other about the z-axis by 90° with each set comprising four partial coils (20).

19. NMR measuring device according to one of the preceding claims, characterised in that a shielded z-gradient coil system (13) is provided for the production of magnetic gradient fields with a largely linear dependence in the measuring volume in a direction parallel to the z-axis, the shielded z-gradient coil system (13) consisting of two cylindrical winding pairs which are arranged around the z-axis mirror-symmetrically to the xy-plane, each of which having a radially inner z-gradient field winding (14) and a radially outer shielding coil winding (15).

20. NMR measuring device according to claim 19, characterised in that the cylindrical winding pairs are arranged in the axial region of the radially outer azimuthal segments (22), whereby the radial separation $r_4$ of the shielding coil winding (15) is smaller than the radial separation $r_2$ of the radially outer segment (22).

21. NMR measuring device according to claim 19 or 20, characterised in that the z-gradient field winding (14) exhibits windings corresponding to $(r_4/r_3)^2$ times those of the shielding coil winding (15), whereby $r_3$ is the radial separation of the z-gradient field winding (14) from the z-axis.

22. NMR measuring device according to one of the preceding claims, characterised in that the gradient coils (14, 20) and if necessary also the compensation (30), shielding (15), and cylindrical coils (40) are potted in plastic within a support body so that an axial bore about the z-axis remains open which is suitable for the acceptance of a person.

23. NMR measuring device according to claim 22, characterised in that a radio frequency (RF) coil system, which can be inserted axially into the axial bore of the support body or transversely into the gap g of the main field magnet, is provided for the production of a largely homogeneous RF field within the measuring volume in the direction of the x- and/or the y-axis.

24. NMR measuring device according to claim 23, characterised in that the RF coil system consists of a closed saddle shaped RF coil (100) which is arranged about the z-axis symmetrically to the zy-plane and to the xy-plane, but asymmetrically to the zx-plane.

25. NMR measuring device according to claim 24, characterised in that the RF coil (100) exhibits four extreme value points $P_1$ through $P_4$ in the direction of the y-axis with the approximate coordinates or preferentially the exact coordinates:

$$P_1: x_1 = 0 \qquad y_1 = +a \qquad z_1 = +a$$

$$P_2: x_2 = 0 \qquad y_2 = +a \qquad z_2 = -a$$

$$P_3: x_3 = -a \qquad y_3 = -a \qquad z_3 = 0$$

$$P_4: x_4 = +a \qquad y_4 = -a \qquad z_4 = 0$$

whereby a corresponds in each case to the same particular path length.

26. NMR measuring device according to claim 25, characterised in that a assumes a value between 20 cm and 50 cm, preferentially, approximately 30 cm.

27. NMR measuring device according to one of the claims 23 through 26, characterised in that the RF coil (100) is comprised from wire, preferentially copper wire, of one or more windings.

28. NMR measuring device according to one of the claims 23 through 26, characterised in that the RF-coil (100) is a stream-line coil made from a closed conducting band, preferentially out of copper sheet metal.

29. NMR measuring device according to one of the claims 23 through 28, characterised in that the coil (100) largely follows the contours of a cylinder about the z-axis.

30. NMR measuring device according to one of the previous claims, characterised in that the main field coil (10) exhibits a pair of mutually identical radially outer field coils which are arranged on a common axis with an axial separation ($g_1$) from another, as well as a pair of likewise mutually identical radially inner field coils which are coaxial to the outer field coils, whereby both coil pairs are arranged symmetrically to a central middle plane (E) which runs perpendicular to the common axis and, during operation of the magnet system (10), the direction of the current in the inner field coils (2a and 2b) is opposite that in the outer field coils (1a and 1b), and whereby the axial separation ($g_1$) of the outer field coils (1a and 1b) lies in the range of 1/4 and 3/4, preferentially approximately 1/2, of the inner diameter ($d_{a2}$) of the outer field coils (1a and 1b), and that the axial separation ($g_2$) of the inner field coils (2a and 2b) is equal to, within a deviation of at most 15%, the axial separation ($g_1$) of the outer field coils (1a and 1b) so that an opening angle for a transverse access opening to the investigational volume is defined which runs transversely to the direction of the homogeneous magnetic field and between the inner field coils (1a, 2b).

31. NMR measuring device according to claim 30, characterised in that an iron shielding is provided, which surrounds, when viewed in the peripheral direction, at least parts of the outside of the field coil system (1a, 1b, 2a, 2b) for the return of magnetic flux, that the iron shielding exhibits a pipe shaped jacket body surrounding the coil system (1a, 1b, 2a, 2b), and that the jacket body has at least one opening whose longitudinal clearance measured parallel to the central axis and whose azimuthal clearance measured at right angles thereto, are determined by the corresponding dimensioning of a transverse access opening of the magnet system (10).

32. NMR measuring device according to claim 31, characterised in that the iron shielding includes beam-shaped shielding elements which extend parallel to the central axis of the coil system (1a, 1b, 2a, 2b) and whose separation in the peripheral direction is determined through the opening size of the transverse access openings.

33. NMR measuring device according to claim 32, characterised in that the iron shielding includes at least three beam-shaped shielding elements.

34. NMR measuring device according to claim 32 or 33, characterised in that the beam-shaped shielding elements are arranged axially symmetric with respect to the central axis.

35. NMR measuring device according to one of the claims 31 through 34, characterised in that the iron shielding has end plates in the shape of ring-shaped discs.

**Revendications**

1. Dispositif de mesure par résonance magnétique nucléaire (RMN), en particulier appareil de tomographie RMN, comprenant une bobine de champ principal, de préférence supraconductrice, capable de générer, dans un volume de mesure dont le centre coïncide avec l'origine d'un système de coordonnées cartésiennes x, y, z, un champ magnétique statique homogène $B_0$ en direction de l'axe z du système de coordonnées, ainsi qu'un système isométrique de bobines de gradients pour générer des champs de gradients magnétiques ayant dans le volume de mesure une allure essentiellement linéaire suivant une direction perpendiculaire à l'axe z, le système de bobines de gradients étant composé d'au moins quatre bobines partielles essentiellement identiques, semblables à des sellettes et disposées symétriquement par rapport à l'origine des coordonnées, radialement et axialement à distance d'elle, qui comportent chacune deux segments électriquement conducteurs s'étendant en direction azimutale autour de l'axe z, dont un segment possède une distance radiale $r_1$ aussi petite que possible et l'autre segment possède une distance radiale $r_2$ aussi grande que possible de l'axe z, les deux segments azimutaux présentant une distance axiale l'un de l'autre en direction de l'axe z, étant reliés entre eux par des tronçons conducteurs (23) et situés collectivement sur une surface r(z) à symétrie de révolution ou ellipsoïdale, chaque bobine partielle ayant plusieurs spires, caractérisé en ce que le segment radialement extérieur (22), ayant la distance radiale $r_2$ de l'axe z, est placé axialement plus près de l'origine des coordonnées, par rapport à l'axe z, que le segment 21 radialement intérieur, ayant la distance radiale $r_1$ de l'axe z, et que l'aimant de champ principal, formé essentiellement par la bobine de champ principal 10, présente une ouverture centrale ou passage à température ordinaire de diamètre $d_B$, ainsi qu'une brèche g en direction axiale autour de l'origine des coordonnées, passage et brèche qui présentent la relation:

$$1{,}6\ g \leq d_B \leq 2{,}1\ g.$$

2. Dispositif de mesure RMN selon la revendication 1, caractérisé en ce que l'espacement axial gg, dans la direction z, de deux bobines partielles (20) situées symétriquement l'une en face de l'autre par rapport au plan xy, est approximativement égal à la largeur de la brèche g.

3. Dispositif de mesure RMN selon la revendication 2, caractérisé en ce que $2 \cdot r_2$ est de peu inférieure à $d_B$.

4. Dispositif de mesure RMN selon une des revendications précédentes, caractérisé en ce que la valeur de la distance radiale $2\ r_1$ des segments azimutaux (21) situés le plus près de l'axe z n'est que de peu supérieure au diamètre d'un cylindre hypothétique offrant suffisamment de place à un patient dans l'appareil de tomographie RMN pendant un examen.

5. Dispositif de mesure RMN selon une des revendications précédentes, caractérisé en ce que les segments radialement extérieurs (22) sont situés sur une surface cylindrique de rayon $r_2$ et les segments radialement intérieurs (21) sont situés sur une surface cylindrique coaxiale de rayon $r_1$.

6. Dispositif de mesure RMN selon une des revendications 1 à 4, caractérisé en ce que les segments (21, 22) sont situés chaque fois sur une surface conique s'ouvrant en direction de l'origine des coordonnées.

7. Dispositif de mesure RMN selon la revendication 6, caractérisé en ce que les segments extérieurs et intérieurs (21, 22) sont situés chaque fois sur la même surface conique.

8. Dispositif de mesure RMN selon une des revendications précédentes, caractérisé en ce que, pour chaque bobine partielle (20), on a prévu une bobine de compensation (30) comportant, dans la zone axiale du segment radialement intérieur (21) de la bobine partielle (20), un segment azimutal intérieur (31) dont la distance radiale $r_1'$ de l'axe z diffère légèrement, de préférence d'environ l'épaisseur radiale du segment (21), de la distance radiale $r_1$ séparant le segment radialement intérieur (21) de la bobine partielle (20) de cet axe.

9. Dispositif de mesure RMN selon la revendication 8, caractérisé en ce que la bobine de compensation (30) comporte un second segment azimutal (32) qui est plus espacé axialement de l'origine des coordonnées, dans la direction z, que le premier segment azimutal (31) de la bobine de compensation (30) et dont la distance radiale $r_2'$ de l'axe z est plus grande que la distance radiale $r_1'$.

10. Dispositif de mesure RMN selon la revendication 8 ou 9, caractérisé en ce que $r_2'$ est au moins environ égale à $r_2$ et est de préférence égale à $r_2$.

11. Dispositif de mesure RMN selon une des revendications 8 à 10, caractérisé en ce que la bobine de compensation (30) possède un autre nombre de spires que la bobine partielle (20).

12. Dispositif de mesure RMN selon une des revendications 8 à 11, caractérisé en ce que l'étendue axiale maximale, en direction de l'axe z, est à peu près égale pour la bobine partielle (20) et la bobine de compensation (30).

13. Dispositif de mesure RMN selon une des revendications 8 à 12, caractérisé en ce que des bobines de blindage (40) sont disposées chacune autour de chaque fois deux bobines partielles (20) situées axialement l'une en face de l'autre, par rapport à l'axe z, sur la surface d'un cylindre entourant l'axe z et ayant un rayon $R_2 \geq r_2$ et une étendue axiale, dans la direction z, qui correspond approximativement à l'étendue axiale de la bobine de champ principal (10), exception faite de la brèche g.

14. Dispositif de mesure RMN selon la revendication 13, caractérisé en ce que les spires des bobines de blindage (40) sont connectées en série avec les spires des bobines partielles (20) correspondantes.

15. Dispositif de mesure RMN selon la revendication 13 ou 14, caractérisé en ce que le nombre de spires des bobines de blindage (40) est plus petit que le nombre de spires des bobines partielles (20) correspondantes.

16. Dispositif de mesure RMN selon une des revendications précédentes, caractérisé en ce que les bobines (20, 30, 40) sont constituées de spires de fils, de préférence de fils de cuivre.

17. Dispositif de mesure RMN selon une des revendications 1 à 15, caractérisé en ce que les bobines (20, 30, 40) sont des bobines "aérodynamiques" constituées en partie au moins d'une bande fermée en elle-même, de préférence en tôle de cuivre.

18. Dispositif de mesure RMN selon une des revendications précédentes, caractérise en ce qu'il comprend deux jeux, mutuellement décalés de 90° autour de l'axe z, de bobines de gradients x et y composées chaque fois de quatre bobines partielles (20).

19. Dispositif de mesure RMN selon une des revendications précédentes, caractérisé en ce qu'il comprend un système blindé de bobines de gradients z (13) pour générer des champs de gradients magnétiques ayant dans le volume de mesure une allure essentiellement linéaire suivant une direction parallèle à l'axe z, système qui est constitué de deux paires d'enroulements cylindriques disposées symétriquement par rapport au plan xy autour de l'axe z, chaque paire comprenant radialement à l'intérieur un enroulement de champ de gradients z (14) et radialement à l'extérieur un enroulement de bobine de blindage (15).

20. Dispositif de mesure RMN selon la revendication 19, caractérisé en ce que les paires d'enroulements cylindriques sont disposées dans la zone axiale des segments azimutaux (22) radialement extérieurs, la distance radiale $r_4$ de l'enroulement de bobine de blindage (15) étant plus petite que la distance radiale $r_2$ du segment (22) radialement extérieur.

21. Dispositif de mesure RMN selon la revendication 19 ou 20, caractérisé en ce que l'enroulement de champ de gradients z (14) présente approximative-

ment $(r_4/r_3)^2$ fois plus de spires que l'enroulement de bobine de blindage (15), $r_3$ étant la distance radiale séparant l'enroulement de champ de gradients z (14) de l'axe z.

22. Dispositif de mesure RMN selon une des revendications précédentes, caractérisé en ce que les bobines de gradients (14, 20) et éventuellement aussi les bobines de compensation (30), de blindage (15) et cylindriques (40) sont compoundées ou scellées à la matière plastique dans un support, de manière à laisser libre, autour de l'axe z, un passage axial qui convient pour recevoir un homme.

23. Dispositif de mesure RMN selon la revendication 22, caractérisé en ce qu'il comprend un système de bobine haute fréquence (HF), destiné à générer dans le volume de mesure un champ HF essentiellement homogène en direction de l'axe x et/ou de l'axe y, système qui peut être glissé axialement dans le passage axial du support ou transversalement dans la brèche g de l'aimant de champ principal.

24. Dispositif de mesure RMN selon la revendication 23, caractérisé en ce que le système de bobine HF est formé d'une bobine HF (100), fermée en elle-même, disposée en forme de selle autour de l'axe z et s'étendant symétriquement par rapport au plan zy et au plan xy, mais de façon asymétrique par rapport au plan zx.

25. Dispositif de mesure RMN selon la revendication 24, caractérisé en ce que la bobine HF (100) présente quatre points extrêmes $P_1$ à $P_4$ en direction de l'axe y, présentant les coordonnées approximatives ou, de préférence, exactes, suivantes

$$P_1: x_1 = 0 \qquad y_1 = +a \qquad z_1 = +a$$

$$P_2: x_2 = 0 \qquad y_2 = +a \qquad z_2 = -a$$

$$P_3: x_3 = -a \qquad y_3 = -a \qquad z_3 = 0$$

$$P_4: x_4 = +a \qquad y_4 = -a \qquad z_4 = 0$$

où a désigne chaque fois une même distance déterminée.

26. Dispositif de mesure RMN selon la revendication 25, caractérisé en ce que la distance a est comprise entre 20 cm et 50 cm et est de préférence d'environ 30 cm.

27. Dispositif de mesure RMN selon une des revendications 23 à 26, caractérisé en ce que la bobine HF (100) est constituée de fils, de préférence de fils de cuivre, formant un ou plusieurs enroulements.

28. Dispositif de mesure RMN selon une des revendications 23 à 26, caractérisé en ce que la bobine HF (100) est une bobine "aérodynamique" constituée d'une bande conductrice fermée en elle-même, de préférence en tôle de cuivre.

29. Dispositif de mesure RMN selon une des revendications 23 à 28, caractérisé en ce que la bobine HF (100) suit essentiellement le contour d'un cylindre autour de l'axe z.

30. Dispositif de mesure RMN selon une des revendications précédentes, caractérisé en ce que la bobine de champ principal (10) comporte une paire de bobines de champ radialement extérieures, identiques entre elles, qui sont disposées sur un axe commun avec un espacement axial $(g_1)$ l'une par rapport à l'autre, ainsi qu'une paire de bobines de champ radialement intérieures, coaxiales aux bobines de champ extérieures, qui sont également identiques entre elles, les deux paires de bobines étant disposées symétriquement par rapport à un plan médian central (E) qui est perpendiculaire à l'axe commun, la direction du courant dans les bobines de champ intérieures (2a et 2b) étant contraire à la direction du courant dans les bobines de champ extérieures (1a et 1b) pendant le fonctionnement du système d'aimant (10), et l'espacement axial $(g_1)$ des bobines de champ extérieures (1a et 1b) étant compris entre 1/4 et 3/4 et correspondant de préférence à environ 1/2 du diamètre intérieur $(d_{a2})$ des bobines de champ extérieures (1a et 1b), et que l'espacement axial $(g_2)$ des bobines de champ intérieures (2a et 2b) étant égal, avec un écart de tout au plus 15%, à l'espacement axial $(g_1)$ des bobines de champ extérieures (1a et 1b), ce qui définit un angle d'ouverture pour une ouverture d'accès transversale au volume d'examen, ouverture qui s'étend transversalement à la direction du champ magnétique homogène et entre les bobines de champ intérieures (2a, 2b).

31. Dispositif de mesure RMN selon la revendication 30, caractérisé en ce qu'il comprend, pour le retour du flux magnétique, un blindage de fer qui entoure le système de bobines de champ (1a, 1b, 2a, 2b) extérieurement, au moins en partie dans le sens circonférentiel, que le blindage de fer comporte une enveloppe tubulaire entourant le système de bobines (1a, 1b, 2a, 2b), et que l'enveloppe présente au moins un évidement dont la dimension longitudinale, mesurée parallèlement à l'axe central, et la largeur azimutale intérieure, mesurée à angle droit par rapport à elle, sont déterminées par les dimensions correspondantes d'une ouverture d'accès transversale du système d'aimant (10).

32. Dispositif de mesure RMN selon la revendication 31, caractérisé en ce que le blindage de fer comprend des éléments de blindage en forme de poutres qui s'étendent parallèlement à l'axe central du système de bobines (1a, 1b, 2a, 2b) et dont l'intervalle, mesuré dans la direction circonférentielle, est déterminé par la largeur d'ouvertures d'accès transversales.

33. Dispositif de mesure RMN selon la revendication 32, caractérisé en ce que le blindage de fer comprend au moins trois éléments de blindage en forme de poutres.

34. Dispositif de mesure RMN selon la revendication 32 ou 33, caractérisé en ce que les éléments de blindage en forme de poutres sont disposés symétriquement par rapport à l'axe central.

35. Dispositif de mesure RMN selon une des revendications 31 à 34, caractérisé en ce que le blindage de fer possède des parois d'extrémité ayant la forme de disques annulaires.

Fig. 1

Fig. 2

Fig. 3

Fig. 4

Fig. 5a

100

Fig. 5b

100

Fig. 6

Fig. 7

Fig. 8

EP 0 586 983 B1

Fig.9a

Fig.9b

Fig. 10

Fig. 11

EP 0 586 983 B1

Fig. 12